# EUROPEAN PATENT APPLICATION

(11) **EP 4 749 514 A1**
(43) Date of publication of application: **27.05.2026**
(21) Application number: 24856657.2
(22) Date of filing: 17.07.2024
(51) Int. Cl.: G06K 7/10, G06K 19/07, G01R 33/07, H04W 4/80

(54) **OPERATION CONTROL METHOD BASED ON TAGGING OF EXTERNAL DEVICE, AND ELECTRONIC DEVICE THEREFOR**

(30) Priority: 22.08.2023 KR 20230109843; 10.11.2023 KR 20230155594
(71) Applicant: Samsung Electronics Co., Ltd., Suwon-si, Gyeonggi-do 16677 (KR)
(72) Inventor: CHOI, Jaewan, Suwon-si, Gyeonggi-do 16677 (KR); KIM, Doorae, Suwon-si, Gyeonggi-do 16677 (KR); KIM, Taewan, Suwon-si, Gyeonggi-do 16677 (KR); KIM, Donghun, Suwon-si, Gyeonggi-do 16677 (KR); YOU, Jaehyoung, Suwon-si, Gyeonggi-do 16677 (KR); LEE, Byunghwa, Suwon-si, Gyeonggi-do 16677 (KR); LEE, Joayoung, Suwon-si, Gyeonggi-do 16677 (KR)
(74) Representative: Appleyard Lees IP LLP
(86) International application number: PCT/KR2024/010229
(87) International publication number: WO 2025/042043

(57) **Abstract**

An embodiment of the present invention may comprise: a plurality of magnetic bodies (201, 203, 205, 207) arranged at a specified distance from each other; one or more hall sensors (211, 213) arranged adjacent to the plurality of magnetic bodies; a memory (130) for storing instructions; and a processor (120). The instructions, when executed by the processor, enable the electronic device to detect a change in a magnetic field of at least one of the plurality of magnetic bodies by using the one or more hall sensors, and control an operation of the electronic device on the basis of the detected change in the magnetic field.

## Description

### [Technical Field]

Various embodiments of the disclosure relate to a method for controlling an operation, based on tagging of an external device, and an electronic device therefor.

### [Background Art]

With the development of digital technology, various types of electronic devices such as mobile communication terminals, personal digital assistants (PDAs), electronic organizers, smartphones, tablet personal computers (PCs), or wearable devices are widely used. Such electronic devices have hardware portions and/or software portions continuously improved to support and enhance functions thereof.

For example, an electronic device may detect an external object (e.g., a wireless charger) that is tagged (or attached) to the rear surface or the lateral surface of the electronic device, by using near field communication (NFC) technology. The electronic device may detect the external object but may not be able to control an operation associated with the external object.

### [Disclosure of Invention]

### [Technical Problem]

An embodiment may disclose a method and an electronic device including multiple magnets or one or more Hall sensors on the rear surface thereof, wherein tagging (or attachment) of an external device (e.g., an accessory) to the electronic device is detected through the one or more Hall sensors, and an application associated with the external device is executed.

### [Solution to Problem]

According to an embodiment of the disclosure, an electronic device may include multiple magnetic bodies 201, 203, 205, 207 spaced apart from each other by a designated distance, one or more Hall sensors 213 disposed adjacent to the multiple magnetic bodies, a memory 130 configured to store instructions, and a processor 120. The instructions may, when executed by the processor, cause the electronic device to detect a change in a magnetic field of at least one of the multiple magnetic bodies using the one or more Hall sensors, and control an operation of the electronic device based on the detected change in the magnetic field.

According to an embodiment of the disclosure, a method of operating an electronic device 101 including multiple magnetic bodies 201, 203, 205, 207 spaced apart from each other by a predetermined distance, one or more Hall sensors 213 disposed adjacent to the multiple magnetic bodies, and a near-field communication module may include detecting tagging of an external device using the near-field communication module, detecting a change in a magnetic field of at least one of the multiple magnetic bodies 201, 203, 205, 207 using the one or more Hall sensors, and controlling an operation of the electronic device based on the detected change in the magnetic field.

### [Advantageous Effects of Invention]

According to an embodiment, by including multiple magnets or one or more Hall sensors on the rear surface of an electronic device, the direction (or location) of an external device (e.g., an accessory) tagged (or attached) to the electronic device can be identified.

According to an embodiment, based on the directions (or location) of an external device tagged to an electronic device, the electronic device can execute different applications or directly execute a specific function of an application.

According to an embodiment, by arranging multiple magnetic bodies in a regular polygonal shape, space for an antenna included in an electronic device can be secured, and a structural design of the electronic device can be efficiently implemented.

According to an embodiment, by enabling an external device to be attached to an electronic device in various directions according to the purpose of the external device, a desired application can be immediately executed merely by attaching the external device to a specific location of the electronic device, thereby improving user convenience.

### [Brief Description of Drawings]

FIG. 1 a block diagram of an electronic device in a network environment according to an embodiment.
FIG. 2A illustrates an example in which a magnetic body and a Hall sensor are attached to an electronic device according to an embodiment.
FIG. 2B is an exploded perspective view illustrating an example in which a magnetic body and a Hall sensor are attached to an electronic device according to an embodiment.
FIG. 3 illustrates an example of disposing a Hall sensor in correspondence with a magnet disposed in an electronic device according to an embodiment.
FIG. 4A illustrates an example in which a magnetic body and a Hall sensor are attached to an external device according to an embodiment.
FIG. 4B is an exploded perspective view illustrating an example in which a magnetic body and a Hall sensor are attached to an external device according to an embodiment.
FIG. 5 illustrates an example of controlling an operation performed when an external device is tagged to an electronic device according to an embodiment.
FIG. 6 is a flowchart illustrating an operation method between an electronic device and an external device according to an embodiment.
FIG. 7 is a flowchart illustrating an operation method of an electronic device according to an embodiment.
FIG. 8A illustrates an example in which an electronic device identifies an attached position of an external device, according to an embodiment.
FIG. 8B illustrates an example in which an electronic device identifies an attachment location of an external device, according to an embodiment.
FIG. 9A illustrates an example in which an electronic device executes an application when an external device is tagged in the vertical direction, according to an embodiment.
FIG. 9B illustrates an example in which an electronic device executes an application when an external device is tagged in the horizontal direction according to an embodiment.
FIG. 9C illustrates another example in which an electronic device executes an application when an external device is tagged in the vertical direction, according to an embodiment.
FIG. 9D illustrates another example in which an electronic device executes an application when an external device is tagged in the horizontal direction, according to an embodiment.
FIG. 10A illustrates an example in which an electronic device executes an application when an external device is tagged in the vertical direction, according to an embodiment.
FIG. 10B illustrates an example in which an electronic device executes an application when an external device is tagged in the horizontal direction, according to an embodiment.
FIG. 10C illustrates an example in which an electronic device executes an application differently according to an attached position of an external device, according to an embodiment.
FIG. 11 is a flowchart illustrating a method for executing an application by an electronic device according to an attachment location of an external device, according to an embodiment.
FIGS. 12A and 12B each illustrate an example in which an electronic device executes an application according to an attachment location of an external device, according to an embodiment.
FIGS. 13A and 13B each illustrate another example in which an electronic device executes an application according to an attachment position of an external device, according to an embodiment.
FIG. 14 is a flowchart illustrating a method for executing an application by an electronic device according to a movement trajectory of an external device, according to an embodiment.
FIGS. 15A and 15B each illustrate an example in which an electronic device executes an application according to a movement trajectory of an external device, according to an embodiment.
FIG. 16 is a flowchart illustrating an operation method of an external device according to an embodiment.
FIGS. 17A to 17C each illustrate an example in which an electronic device identifies an attachment location of an external device, according to an embodiment.
FIG. 17D illustrates an example in which an electronic device detects a movement trajectory of an external device, according to an embodiment.
FIGS. 18A and 18B each illustrate an example of the type of an external device tagged to an electronic device according to an embodiment.

### [Mode for the Invention]

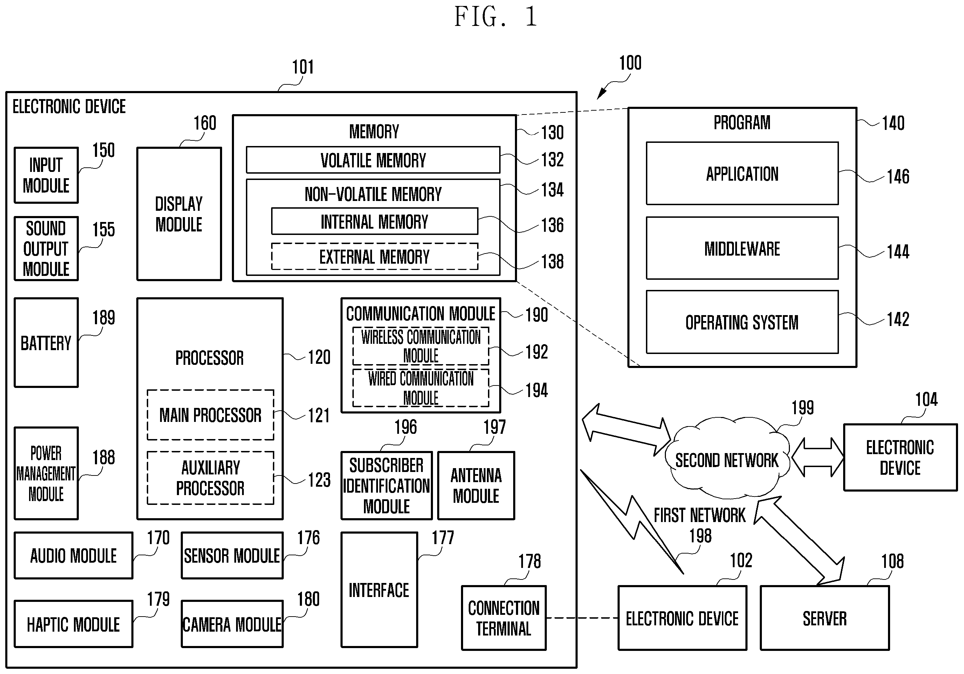

Fig. 1 is a block diagram illustrating an electronic device 101 in a network environment 100 according to certain embodiments.

Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5th generation (5G) network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4th generation (4G) network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to certain embodiments, the antenna module 197 may form a mmWave antenna module. According to an embodiment, the mmWave antenna module may include a printed circuit board, an RFIC disposed on a first surface (e.g., the bottom surface) of the PCB, or adjacent to the first surface and capable of supporting a designated high-frequency band (e.g., the mmWave band), and a plurality of antennas (e.g., array antennas) disposed on a second surface (e.g., the top or a side surface) of the PCB, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments disclosed herein may be one of various types of electronic devices. The electronic devices may include, for example, a portable communication device (e.g., a smart phone), a computer device, a portable multimedia device, a portable medical device, a camera, a wearable device, or a home appliance. The electronic device according to embodiments of the disclosure is not limited to those described above.

It should be appreciated that various embodiments of the disclosure and the terms used therein are not intended to limit the technological features set forth herein to particular embodiments and include various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "a first", "a second", "the first", and "the second" may be used to simply distinguish a corresponding element from another, and does not limit the elements in other aspect (e.g., importance or order). It is to be understood that if an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used herein, the term "module" may include a unit implemented in hardware, software, or firmware, and may be interchangeably used with other terms, for example, "logic," "logic block," "component," or "circuit". The "module" may be a minimum unit of a single integrated component adapted to perform one or more functions, or a part thereof. For example, according to an embodiment, the "module" may be implemented in the form of an application-specific integrated circuit (ASIC).

Various embodiments as set forth herein may be implemented as software (e.g., the program 140) including one or more instructions that are stored in a storage medium (e.g., the internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities mat be separately disposed in any other element. According to various embodiments, one or more of the above-described elements may be omitted, or one or more other elements may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration. According to various embodiments, operations performed by the module, the program, or another element may be carried out sequentially, in parallel, repeatedly, or heuristically, or one or more of the operations may be executed in a different order or omitted, or one or more other operations may be added.

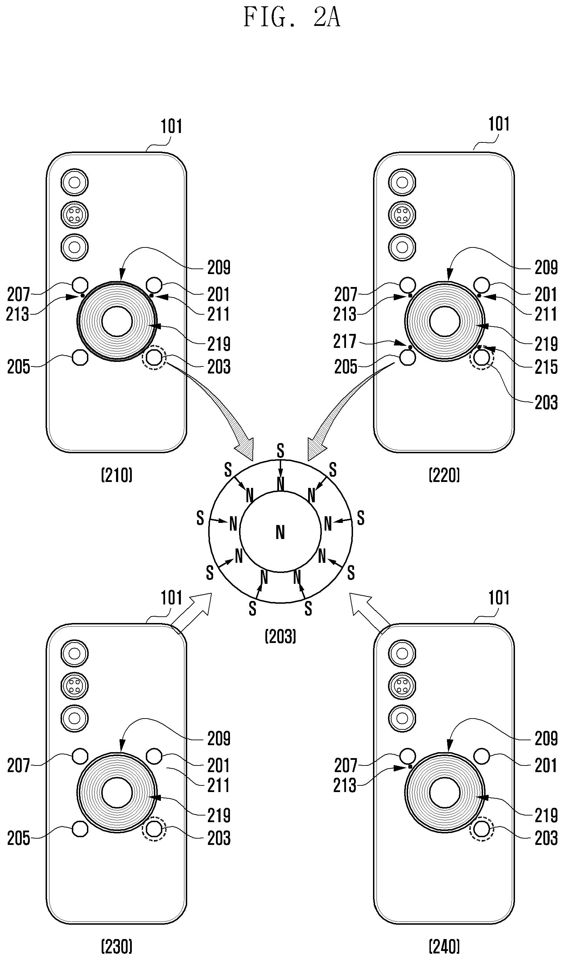

FIG. 2A illustrates an example in which a magnetic body and a Hall sensor are attached to an electronic device according to an embodiment.

Referring to FIG. 2A, an electronic device (e.g., the electronic device 101 of FIG. 1) according to an embodiment may include, on the rear surface thereof, multiple magnetic bodies (or magnet modules) 201, 203, 205, and 207, or at least one Hall sensor 213 (e.g., the sensor module 176 of FIG. 1). Although the drawing illustrates an example in which the multiple magnetic bodies 201, 203, 205, and 207 and the at least one Hall sensor 213 are directly included on the rear surface of the electronic device, the multiple magnetic bodies 201, 203, 205, and 207 and the at least one Hall sensor 213 may be disposed in an external case attachable (or mountable) to the electronic device 101. That is, the disclosure may be performed by mounting, on the electronic device 101, an external case including the multiple magnetic bodies 201, 203, 205, and 207 and the at least one Hall sensor 213.

As a first embodiment 210, the electronic device 101 may include four magnetic bodies 201, 203, 205, and 207 and two Hall sensors 211 and 213. The four magnetic bodies 201, 203, 205, and 207 may include a first magnetic body 201, a second magnetic body 203, a third magnetic body 205, and a fourth magnetic body 207. The four magnetic bodies 201, 203, 205, and 207 may be spaced apart from each other. For example, the four magnetic bodies 201, 203, 205, and 207 may be disposed around a wireless charging coil 219 in different directions. The four magnetic bodies 201, 203, 205, and 207 may be formed in a regular polygonal arrangement structure at the same distance from the center of the wireless charging coil 219. When the four magnetic bodies 201, 203, 205, and 207 are arranged in a regular polygon, more vacant space may be provided compared to a circular arrangement, thereby making it easier to secure space for an antenna and to design.

A Hall sensor (or a magnetic sensing sensor) is configured to detect a change in the magnetic field of at least one of the four magnetic bodies 201, 203, 205, and 207, and may be disposed to correspond to (or be adjacent to) the four magnetic bodies 201, 203, 205, and 207. For example, a first Hall sensor 211 may be disposed at a location corresponding to the first magnetic body 201, and a second Hall sensor 213 may be disposed at a location corresponding to the fourth magnetic body 207. Alternatively, unlike the drawing, the two Hall sensors 211 and 213 may be disposed adjacent to (or corresponding to) the second magnetic body 203 or the third magnetic body 205. The drawing is provided merely to aid understanding of the disclosure, and the disclosure is not limited by the drawing.

As a second embodiment 220, the electronic device 101 may include four magnetic bodies 201, 203, 205, and 207 and four Hall sensors 211, 213, 215, and 217. The first magnetic body 201, the second magnetic body 203, the third magnetic body 205, and the fourth magnetic body 207 may be spaced apart from each other. For example, the first magnetic body 201, the second magnetic body 203, the third magnetic body 205, and the fourth magnetic body 207 may be disposed around the wireless charging coil 219 in different directions. The four Hall sensors 211, 213, 215, and 217 may be disposed to correspond to the four magnetic bodies 201, 203, 205, and 207. For example, the first Hall sensor 211 may be disposed at a location corresponding to the first magnetic body 201, the second Hall sensor 213 may be disposed at a location corresponding to the fourth magnetic body 207, the third Hall sensor 215 may be disposed at a location corresponding to the second magnetic body 203, and the fourth Hall sensor 217 may be disposed at a location corresponding to the third magnetic body 205.

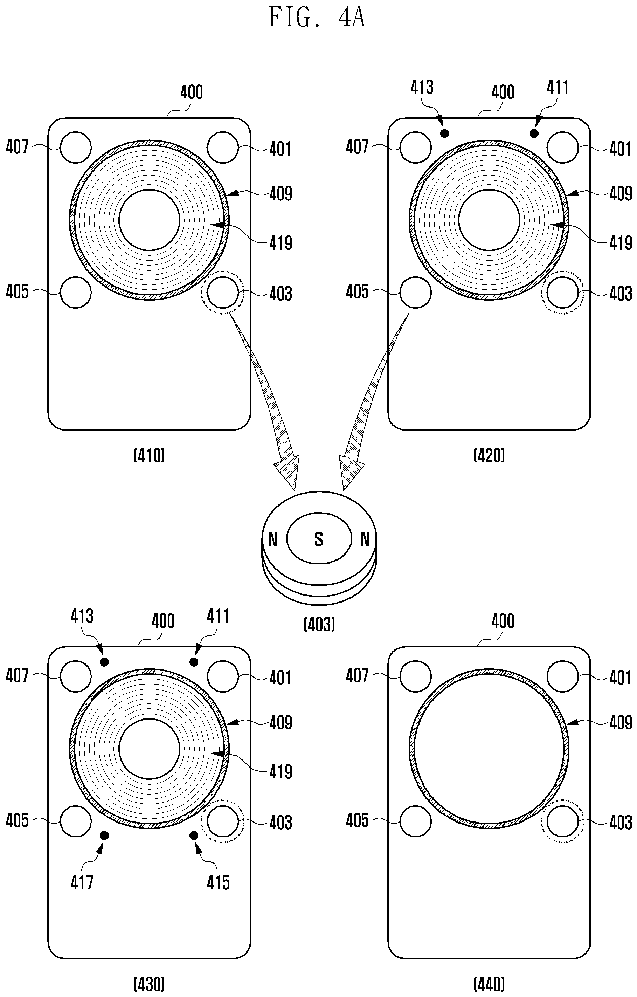

As a third embodiment 230, the electronic device 101 may include four magnetic bodies 201, 203, 205, and 207. The first magnetic body 201, the second magnetic body 203, the third magnetic body 205, and the fourth magnetic body 207 may be spaced apart from each other. For example, the first magnetic body 201, the second magnetic body 203, the third magnetic body 205, and the fourth magnetic body 207 may be disposed around the wireless charging coil 219 in different directions. The electronic device 101 may not include a Hall sensor. In this case, an external device (e.g., the external device 400 of FIG. 4A) tagged to (or contacting, mounted on, or attached to) the electronic device 101 may include a Hall sensor.

As a fourth embodiment 240, the electronic device 101 may include three magnetic bodies 201, 203, and 207 and at least one Hall sensor (e.g., the second Hall sensor 213). The first magnetic body 201, the second magnetic body 203, and the fourth magnetic body 207 may be spaced apart from each other. For example, the first magnetic body 201, the second magnetic body 203, and the fourth magnetic body 207 may be disposed around the wireless charging coil 219 in different directions. The second Hall sensor 213 may be disposed to correspond to (or be adjacent to) the fourth magnetic body 207. Alternatively, unlike the drawing, the electronic device 101 may include only the first Hall sensor 211 corresponding to the first magnetic body 201. The drawing is provided merely to aid understanding of the disclosure, and the disclosure is not limited by the drawing.

According to an embodiment, each of the multiple magnetic bodies 201, 203, 205, and 207 may be formed in a structure in which an outer S magnetic body radially surrounds such that S magnetism is oriented toward the inner N magnetic body. For example, each of the multiple magnetic bodies 201, 203, 205, and 207 may be arranged in a Halbach array. However, the multiple magnetic bodies 201, 203, 205, and 207 may have a magnetic body arrangement other than the Halbach array.

According to an embodiment, the electronic device 101 may further include a wireless charging coil 219 and a near field communication (NFC) antenna 209. Although the drawing illustrates the NFC antenna 209 (or an NFC communication module) as being disposed in a circular shape surrounding the wireless charging coil 219, the NFC antenna 209 may be formed in a rectangular shape adjacent to the lateral surface (or an edge) of the electronic device 101. An arrangement location and a formed size of the wireless charging coil 219 or the NFC antenna 209 included in the electronic device 101 may be different from those illustrated. The drawing is provided merely to aid understanding of the disclosure, and the disclosure is not limited by the drawing.

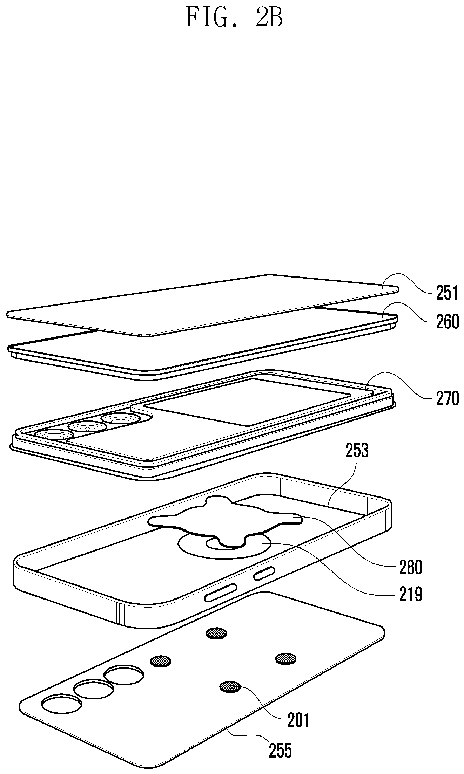

FIG. 2B is an exploded perspective view illustrating an example in which a magnetic body and a Hall sensor are attached to an electronic device according to an embodiment.

Referring to FIG. 2B, components that are substantially identical to those of the electronic device 101 described with reference to the preceding drawings are denoted by the same reference numerals, and detailed descriptions thereof may be omitted. The electronic device 101 may include a display module 260 (e.g., the display module 160 of FIG. 1) under a front glass 251, and a battery and a main board 270 under the display module 260. The electronic device 101 may include, within a frame 253, a module case 280 corresponding to multiple magnetic bodies 201 to 207 and the wireless charging coil 219. The electronic device 101 may include (or dispose) the multiple magnetic bodies 201 to 207 on a rear cover 255.

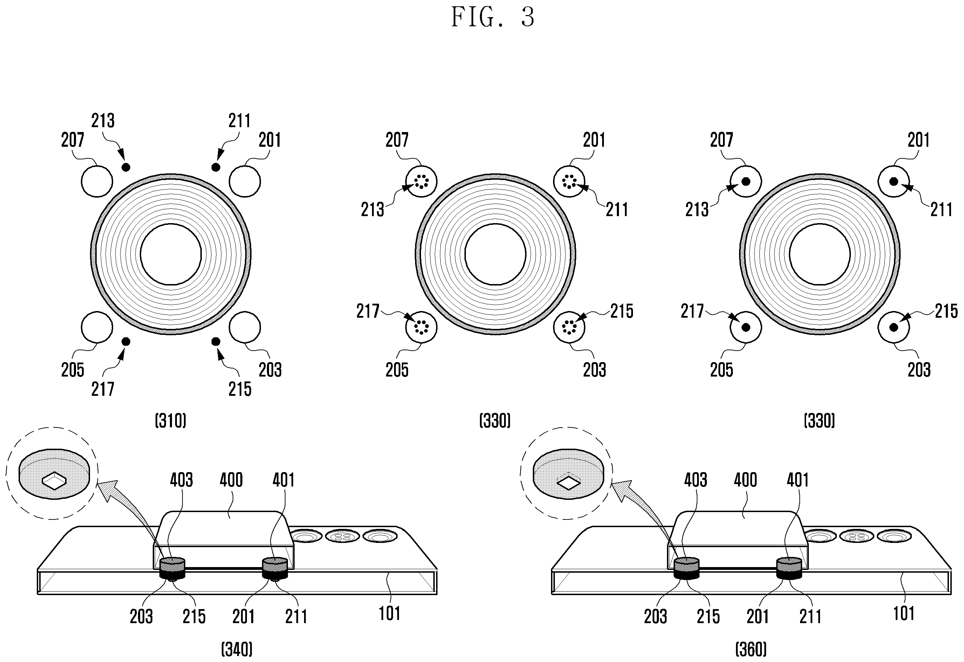

FIG. 3 illustrates an example of disposing a Hall sensor in correspondence with a magnet disposed in an electronic device according to an embodiment.

Referring to FIG. 3, an electronic device (e.g., the electronic device 101 of FIG. 1) according to an embodiment may include, on the rear surface thereof, multiple magnetic bodies (or magnet modules) 201, 203, 205, and 207, and multiple Hall sensors 211, 213, 215, and 217. In FIG. 3, when the electronic device 101 is implemented as the second embodiment 220 of FIG. 2A, an example of an arrangement of the multiple Hall sensors 211, 213, 215, and 217 may be described. However, even when the electronic device 101 is implemented as the first embodiment 210 or the fourth embodiment 240 of FIG. 2A, the same or similar arrangement may be applied.

As a first embodiment 310, the multiple Hall sensors 211, 213, 215, and 217 may be disposed at locations adjacent to the multiple magnetic bodies 201, 203, 205, and 207. The Hall sensors are configured to detect changes in the magnetic fields of magnetic bodies, and the multiple Hall sensors 211, 213, 215, and 217 may be disposed so as to correspond to the multiple magnetic bodies 201, 203, 205, and 207. When the multiple Hall sensors 211, 213, 215, and 217 are disposed at positions adjacent to the multiple magnetic bodies 201, 203, 205, and 207, a separate shielding member may not be formed between the multiple Hall sensors 211, 213, 215, and 217 and the multiple magnetic bodies 201, 203, 205, and 207.

As a second embodiment 320, the multiple Hall sensors 211, 213, 215, and 217 may be disposed in a direction perpendicular to the multiple magnetic bodies 201, 203, 205, and 207. For example, referring to a first attachment cross-sectional view 340, when the multiple magnetic bodies 201, 203, 205, and 207 are disposed on a rear cover (e.g., the rear cover 255 of FIG. 2B) of the electronic device 101, the multiple Hall sensors 211, 213, 215, and 217 may be disposed under the multiple magnetic bodies 201, 203, 205, and 207 in a front direction of the electronic device 101. In this case, the multiple Hall sensors 211, 213, 215, and 217 may further include a shielding member between the multiple magnetic bodies 201, 203, 205, and 207.

Referring to the first attachment cross-sectional view 340, the first Hall sensor 211 may be disposed under the first magnetic body 201, and the third Hall sensor 215 may be disposed under the second magnetic body 203. When a first magnetic body 401 of an external device 400 is attached to the first magnetic body 201 of the electronic device 101, the first Hall sensor 211 may detect a change in magnetic field intensity or wavelength of the first magnetic body 201. When a second magnetic body 403 of the external device 400 is attached to the second magnetic body 203 of the electronic device 101, the third Hall sensor 215 may detect a change in magnetic field intensity or wavelength of the second magnetic body 203.

As a third embodiment 330, the multiple Hall sensors 211, 213, 215, and 217 may be disposed (or included) within the multiple magnetic bodies 201, 203, 205, and 207. For example, referring to a second attachment cross-sectional view 350, the multiple Hall sensors 211, 213, 215, and 217 may be disposed within (e.g., at centers of) the multiple magnetic bodies 201, 203, 205, and 207. In this case, the multiple Hall sensors 211, 213, 215, and 217 may further include a shielding member between the multiple magnetic bodies 201, 203, 205, and 207.

Referring to the second attachment cross-sectional view 350, the first Hall sensor 211 may be disposed under the first magnetic body 201, and the third Hall sensor 215 may be disposed under the second magnetic body 203. When the first magnetic body 401 of the external device 400 is attached to the first magnetic body 201 of the electronic device 101, the first Hall sensor 211 may detect a change in magnetic field intensity or wavelength of the first magnetic body 201. When the second magnetic body 403 of the external device 400 is attached to the second magnetic body 203 of the electronic device 101, the third Hall sensor 215 may detect a change in magnetic field intensity or wavelength of the second magnetic body 203.

FIG. 4A illustrates an example in which a magnetic body and a Hall sensor are attached to an external device according to an embodiment.

Referring to FIG. 4A, an external device 400 according to an embodiment may be a type of detachable accessory for an electronic device (e.g., the electronic device 101 of FIG. 1). According to an embodiment, the external device 400 may include at least one of a stand including a wireless charging pad, a vehicle cradle, a tripod mount, a lighting device, a photographic filter, or an electronic pen. This external device 400 may include multiple magnetic bodies (or magnet modules) 401, 403, 405, and 407, or at least one or more Hall sensors 411 and 413 (e.g., the sensor module 176 of FIG. 1). In order to distinguish the magnetic bodies included in the external device 400 from the magnetic bodies included in the electronic device 101, the magnetic bodies included in the external device 400 may hereinafter be described as "external magnetic bodies." However, the disclosure is not limited by such description. The external device 400 may store, in a memory, device information of the external device 400 including a name (or an identifier) or a type of the external device 400.

As a first embodiment 410, the external device 400 may include at least one of four external magnetic bodies 401, 403, 405, and 407, an NFC tag 409 (or an NFC antenna or an NFC communication module), and a wireless charging coil 419. The four external magnetic bodies 401, 403, 405, and 407 may include a first external magnetic body 401, a second external magnetic body 403, a third external magnetic body 405, and a fourth external magnetic body 407. The four external magnetic bodies 401, 403, 405, and 407 may be spaced apart from each other. For example, the four external magnetic bodies 401, 403, 405, and 407 may be disposed around the wireless charging coil 419 in different directions. The four external magnetic bodies 401, 403, 405, and 407 may be formed in a regular polygonal arrangement structure at the same distance from the center of the wireless charging coil 419. When the four external magnetic bodies 401, 403, 405, and 407 are arranged in a regular polygon, more vacant space may be provided than in a circular arrangement, thereby making it easier to secure space for an antenna and to design. The external device 400 may detect tagging (or contact or attachment) with the electronic device 101 through the NFC tag 409. The external device 400 may transmit (or share) power to the electronic device 101 through the wireless charging coil 419.

As a second embodiment 420, the external device 400 may include at least one of four external magnetic bodies 401, 403, 405, and 407, two external Hall sensors 411 and 413, an NFC tag 409, and a wireless charging coil 419. The four external magnetic bodies 401, 403, 405, and 407 may include a first external magnetic body 401, a second external magnetic body 403, a third external magnetic body 405, and a fourth external magnetic body 407. The four external magnetic bodies 401, 403, 405, and 407 may be spaced apart from each other. For example, the four external magnetic bodies 401, 403, 405, and 407 may be disposed around the wireless charging coil 419 in different directions.

The two external Hall sensors 411 and 413 may be disposed to correspond to (or be adjacent to) the four external magnetic bodies 401, 403, 405, and 407. For example, a first external Hall sensor 411 may be disposed at a location corresponding to the first external magnetic body 401, and a second external Hall sensor 413 may be disposed at a location corresponding to the fourth external magnetic body 407. Alternatively, unlike the drawing, the two external Hall sensors 411 and 413 may be disposed adjacent to (or corresponding to) the second external magnetic body 403 or the third external magnetic body 405. The drawing is provided merely to aid understanding of the disclosure, and the disclosure is not limited by the drawing.

As a third embodiment 430, the external device 400 may include at least one of four external magnetic bodies 401, 403, 405, and 407, four external Hall sensors 411, 413, 415, and 417, an NFC tag 409, and a wireless charging coil 419. The four external magnetic bodies 401, 403, 405, and 407 may include a first external magnetic body 401, a second external magnetic body 403, a third external magnetic body 405, and a fourth external magnetic body 407. The four external magnetic bodies 401, 403, 405, and 407 may be spaced apart from each other. For example, the four external magnetic bodies 401, 403, 405, and 407 may be disposed around the wireless charging coil 419 in different directions. The four external Hall sensors 411, 413, 415, and 417 may be disposed to correspond to the four external magnetic bodies 401, 403, 405, and 407. For example, the first external Hall sensor 411 may be disposed at a location corresponding to the first external magnetic body 401, the second external Hall sensor 413 may be disposed at a location corresponding to the fourth external magnetic body 407, the third external Hall sensor 415 may be disposed at a location corresponding to the second external magnetic body 403, and the fourth external Hall sensor 417 may be disposed at a location corresponding to the third external magnetic body 405.

As a fourth embodiment 440, the external device 400 may include at least one of four external magnetic bodies 401, 403, 405, and 407 and an NFC tag 409. The four external magnetic bodies 401, 403, 405, and 407 may include a first external magnetic body 401, a second external magnetic body 403, a third external magnetic body 405, and a fourth external magnetic body 407. The four external magnetic bodies 401, 403, 405, and 407 may be spaced apart from each other.

According to an embodiment, each of the multiple external magnetic bodies 401, 403, 405, and 407 may be formed in a structure in which an inner S magnetic body radially surrounds such that S magnetism is oriented toward an outer N magnetic body. For example, each of the multiple external magnetic bodies 401, 403, 405, and 407 may be arranged in a Halbach array. However, the multiple external magnetic bodies 401, 403, 405, and 407 may have a magnetic body arrangement other than the Halbach array.

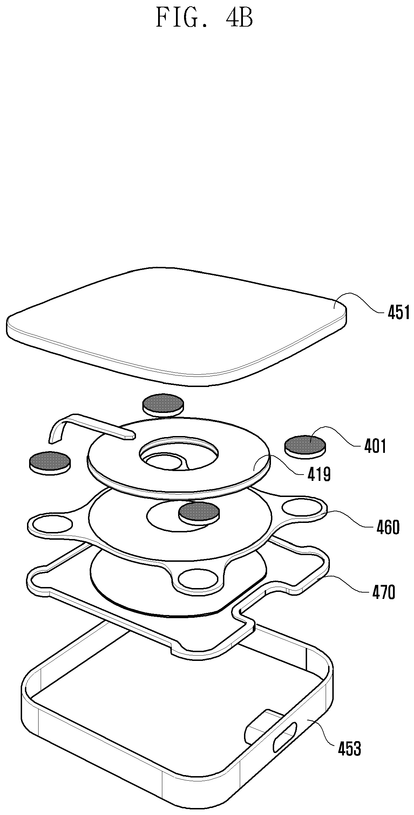

FIG. 4B is an exploded perspective view illustrating an example in which a magnetic body and a Hall sensor are attached to an external device according to an embodiment.

Referring to FIG. 4B, components that are substantially identical to those of the external device 400 described with reference to the preceding drawings are denoted by the same reference numerals, and detailed descriptions thereof may be omitted. The external device 400 may include a cover 451, a module case 460, a PCB board 470, and a case 453. The module case 460 may include (or have disposed) multiple external magnetic bodies 401 to 407 and a wireless charging coil 419. According to an embodiment, the module case 460 may further include an external Hall sensor (e.g., a first external Hall sensor 211) or an NFC antenna 209.

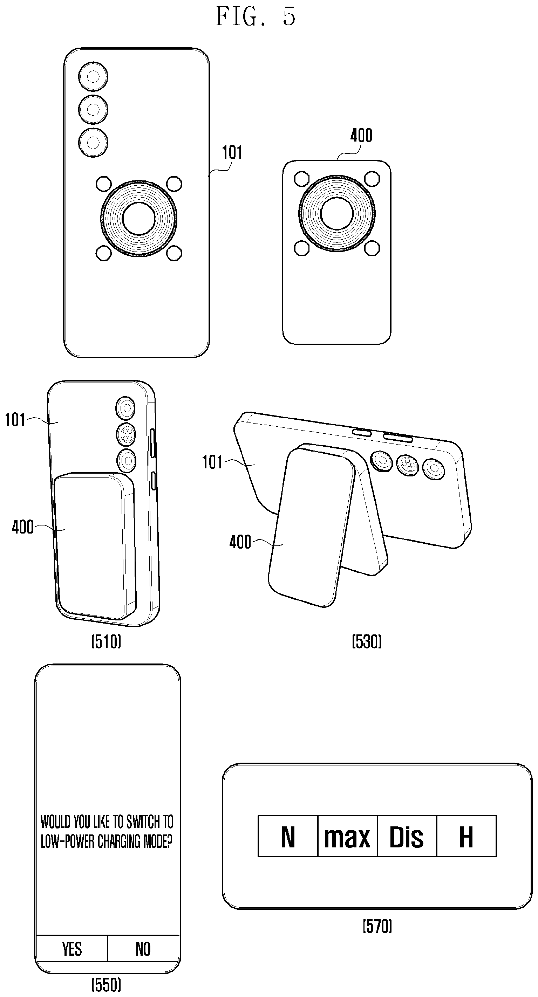

FIG. 5 illustrates an example of controlling an operation performed when an external device is tagged to an electronic device according to an embodiment.

Referring to FIG. 5, an electronic device (e.g., the electronic device 101 of FIG. 1) according to an embodiment may detect that an external device (e.g., the external device 400 of FIG. 4A) is tagged (or contacted or attached). To this end, the electronic device 101 may be implemented as one of the first embodiment 210 to the fourth embodiment 240 of FIG. 3A. The external device 400 may be implemented as at least one of the first embodiment 410 to the fourth embodiment 440 of FIG. 4A.

As in a first attachment example 510, when the external device 400 is attached (or tagged) to the electronic device 101 in the vertical direction, the electronic device 101 may provide a first user interface 550. The electronic device 101 may detect a change in a magnetic field of at least one of multiple magnetic bodies (e.g., first magnetic body 201 to fourth magnetic body 207 of FIG. 3A) by using at least one Hall sensor (e.g., first Hall sensor 211 to fourth Hall sensor 217 of FIG. 3A). Based on the detected change in the magnetic field, the electronic device 101 may identify (or determine) that the external device 400 is attached in the vertical direction. For example, when the external device 400 is a wireless charging pad stand, the first user interface 550 may include a notification (or a pop-up) for executing a wireless charging (or low-power charging) function (or mode). The electronic device 101 may perform wireless charging based on a user input through the first user interface 550.

As in a second attachment example 530, when the external device 400 is attached to the electronic device 101 in the horizontal direction, the electronic device 101 may provide a second user interface 570 The electronic device 101 may detect a change in a magnetic field of at least one of multiple magnetic bodies (e.g., first magnetic body 201 to fourth magnetic body 207 of FIG. 3A) by using at least one Hall sensor (e.g., first Hall sensor 211 to fourth Hall sensor 217 of FIG. 3A). Based on the detected change in the magnetic field, the electronic device 101 may identify (or determine) that the external device 400 is attached in the horizontal direction. For example, when the external device 400 is a wireless charging pad stand, the second user interface 550 may include an application list or an execution screen of an application related to a video streaming service. The electronic device 101 may provide the video streaming service while performing wireless charging based on a user input through the second user interface 570.

According to an embodiment of the disclosure, an electronic device may include multiple magnetic bodies 201, 203, 205, 207 spaced apart from each other by a designated distance, one or more Hall sensors 211, 213 disposed adjacent to the multiple magnetic bodies, a memory 130 configured to store instructions, and a processor 120. The instructions may, when executed by the processor, cause the electronic device to detect a change in a magnetic field of at least one of the multiple magnetic bodies using the one or more Hall sensors, and control an operation of the electronic device based on the detected change in the magnetic field.

The one or more Hall sensors may be included such that the number thereof is less than or greater than the number of the multiple magnetic bodies or corresponds to the number of the multiple magnetic bodies.

The electronic device may further include a display module 260. The one or more Hall sensors may be disposed below the display module, and the multiple magnetic bodies may be disposed below the one or more Hall sensors disposed below the display module to vertically overlap the one or more Hall sensors, or the one or more Hall sensors disposed below the display module may be disposed within the multiple magnetic bodies.

Each of the multiple magnetic bodies may be arranged in a Halbach array.

The electronic device may further include a wireless charging coil and a near-field communication module disposed to surround the wireless charging coil, and the multiple magnetic bodies may be arranged around the near-field communication module.

The instructions may, when executed by the processor, cause the electronic device to detect tagging of an external device using the near-field communication module, and identify the external device.

The electronic device may further include a display module 260, and the instructions may, when executed by the processor, cause the electronic device to display information of the identified external device on the display module.

The instructions may, when executed by the processor, cause the electronic device to detect a change in a magnetic field through the one or more Hall sensors when tagging of an external device is detected, identify an attached position of the external device based on the detected change in the magnetic field, and execute an application based on the identified attached position of the external device.

The instructions may, when executed by the processor, cause the electronic device to establish a low-power Bluetooth connection with the external device, and transmit, through the low-power Bluetooth connection, a command associated with the executed application to the external device.

The instructions may, when executed by the processor, cause the electronic device to detect a change in a magnetic field through the one or more Hall sensors when tagging of the external device is detected, identify an attachment location of the external device based on the detected change in the magnetic field, and execute a first function of an application when the identified attachment location is a first location, and execute a second function of the application when the identified attachment location is a second location or execute a first application when the identified attachment location is the first location and execute a second application when the identified attachment location is the second location.

The instructions may, when executed by the processor, cause the electronic device to detect a change in a magnetic field through the one or more Hall sensors when tagging of the external device is detected, detect a movement trajectory of the external device based on the detected change in the magnetic field, and execute a designated application or a designated function of a currently displayed application based on the detected movement trajectory.

The instructions may, when executed by the processor, cause the electronic device to collect a usage history of the electronic device while the external device is attached to the electronic device, and further in consideration of the collected usage history of the electronic device, execute an application differently according to on an attached position of the external device.

The instructions may, when executed by the processor, cause the electronic device to execute a specific application based on at least one of a type of an external device tagged to the electronic device, an attached position of the external device, an attachment location of the external device, a movement trajectory of the external device, or the usage history of the electronic device.

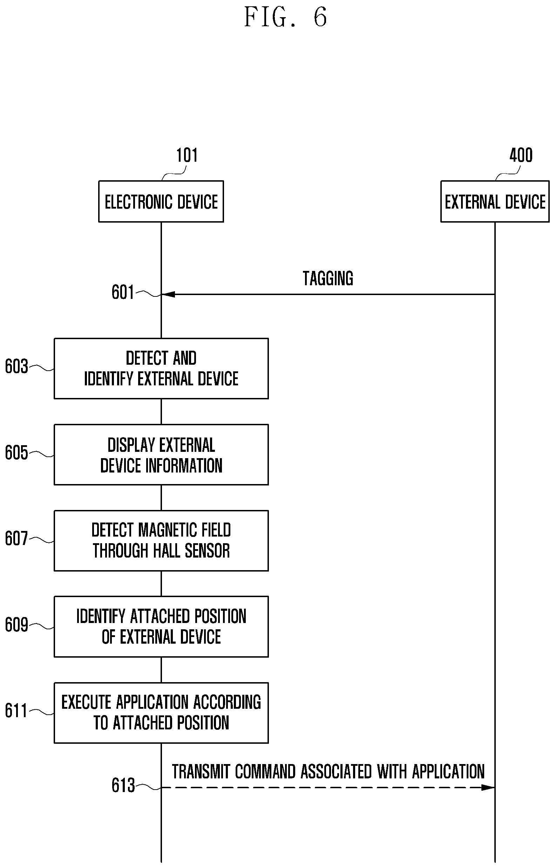

FIG. 6 is a flowchart 600 illustrating an operation method between an electronic device and an external device according to an embodiment.

Referring to FIG. 6, in operation 601, an external device (e.g., the external device 400 of FIG. 4A) according to an embodiment may be tagged to (or attached to, contacted with, or mounted on) an electronic device (e.g., the electronic device 101 of FIG. 1) according to an embodiment. According to an embodiment, the external device 400 may include at least one of a stand including a wireless charging pad, a vehicle cradle, a tripod mount, a lighting device, a photographic filter, or an electronic pen. This external device 400 may include multiple external magnetic bodies (or magnet modules) (e.g., the multiple magnetic bodies 401, 403, 405, and 407 of FIG. 4A) and an NFC tag (e.g., the NFC tag 409 of FIG. 4A). Alternatively, according to an embodiment, the external device 400 may further include a wireless charging coil (e.g., the wireless charging coil 419 of FIG. 4A) or at least one or more Hall sensors (e.g., the at least one or more Hall sensors 411 and 413 of FIG. 4A) (e.g., the sensor module 176 of FIG. 1).

In operation 603, the electronic device 101 may detect the external device 400 and identify the external device 400. The electronic device 101 may include multiple magnetic bodies (e.g., the multiple magnetic bodies 201 to 207 of FIG. 2A), one or more Hall sensors (e.g., the multiple Hall sensors 211 to 217 of FIG. 2A), a wireless charging coil (e.g., the wireless charging coil 219 of FIG. 2A), and an NFC antenna (e.g., the NFC antenna 209 of FIG. 2A). The electronic device 101 may detect tagging of the external device 400 by using the NFC antenna (e.g., the NFC antenna 209 of FIG. 2A). When the NFC tag 409 of the external device 400 corresponds to the NFC antenna 209, the electronic device 101 may detect tagging (or attachment) of the external device 400. The electronic device 101 may identify the external device 400 by reading tag information (or a tag value) of the external device 400. The tag information of the external device 400 may be stored in advance in the external device 400. The tag information may include device information of the external device 400. The device information of the external device 400 may include a name (or an identifier) or a type of the external device 400.

In operation 605, the electronic device 101 may display information of the external device 400. The electronic device 101 may notify a user, through a display (e.g., the display module 160 of FIG. 1), that the external device 400 is at least one of a stand capable of wireless charging, a vehicle cradle, a tripod mount, a lighting device, a photographic filter, or an electronic pen. The electronic device 101 may display information of the external device 400 while the external device 400 is attached.

In operation 607, the electronic device 101 may detect magnetic fields of multiple magnetic bodies 201 to 207 through a Hall sensor 213. The electronic device 101 may detect the magnetic fields of the multiple magnetic bodies 201 to 207 through the Hall sensor 213 while the external device 400 is attached. The electronic device 101 may detect the magnetic fields of the multiple magnetic bodies 201 to 207 by including two Hall sensors 211 and 213 or by using four Hall sensors 211 to 217. Hereinafter, a case in which the electronic device 101 includes four Hall sensors 211 to 217 will be described. However, the disclosure is not limited by such description. The multiple magnetic bodies 201 to 207 included in the electronic device 101 may be formed in a structure in which an outer S magnetic body radially surrounds such that S magnetism is oriented toward an inner N magnetic body. The multiple external magnetic bodies 401 to 407 included in the external device 400 may be formed in a structure in which an inner S magnetic body radially surrounds such that S magnetism is oriented toward an outer N magnetic body. When the multiple magnetic bodies 201 to 207 are tagged to (or attached to) the multiple external magnetic bodies 401 to 407 included in the external device 400, the four Hall sensors 211 to 217 may detect a change in the intensity and wavelength of magnetic fields.

In operation 609, the electronic device 101 may identify a position at which the external device 400 is attached. The attached position (or an attachment direction or a tagging mode) may indicate whether the external device 400 is attached to the electronic device 101 in the horizontal direction (or the lateral direction) or in the vertical direction (or the longitudinal direction). For example, when the electronic device 101 includes two Hall sensors 211 and 213, at least two magnetic bodies 401 and 407 of the external device 400 may generate a stronger magnetic field intensity than the remaining two magnetic bodies 403 and 405. This may be for identifying the attached position of the external device 400 by using the two Hall sensors 211 and 213. Alternatively, when the electronic device 101 includes four Hall sensors 211 to 217, the electronic device 101 may identify the attached position of the external device 400 based on magnetic field changes caused by the multiple magnetic bodies 201 to 207. The electronic device 101 may identify the attached position of the external device 400 while the external device 400 is attached.

In operation 611, the electronic device 101 may execute an application according to the attached position of the external device 400. For example, in case that the external device 400 is a wireless charging pad stand, the electronic device 101 may execute an application (or a pop-up or a notification) related to wireless charging when the external device 400 is attached to the electronic device 101 in the vertical direction, and the electronic device 101 may execute an application related to a video streaming service when the external device 400 is attached to the electronic device 101 in the horizontal direction. For example, in case that the external device 400 is a vehicle cradle, the electronic device 101 may execute a map application when the external device 400 is attached to the electronic device 101 in the vertical direction, and the electronic device 101 may execute an application related to a music streaming service when the external device 400 is attached to the electronic device 101 in the horizontal direction. The electronic device 101 may execute an application according to the attached position of the external device 400 while the external device 400 is attached.

According to an embodiment, after attaching the external device 400, the electronic device 101 may collect a usage history of the electronic device 101, and may execute an application differently according to the attached position of the external device 400 by further considering the collected usage history of the electronic device 101. A pattern of using the electronic device 101 after attaching the external device 400 may be different for each user. Based on the usage history of the electronic device 101, the electronic device 101 may execute an application that provides a function desired by a user such that the user may immediately perform the desired function without additional user input. The electronic device 101 may execute various applications or execute a specific function of an application without additional user input according to what the external device 400 is or according to the attached position of the external device 400.

In operation 613, the electronic device 101 may transmit a command (or instruction)associated with the executed application to the external device 400. To perform operation 613, the electronic device 101 may be connected to the external device 400 via low-power Bluetooth before operation 613. For example, the command may be to start wireless charging or to turn on a light source. However, when wireless charging is automatically started or a light source is turned on as the external device 400 is tagged to the electronic device 101 or after a predetermined time elapses, operation 613 may be omitted. The electronic device 101 may transmit the command (or the instruction) associated with the executed application to the external device 400 while the external device 400 is attached.

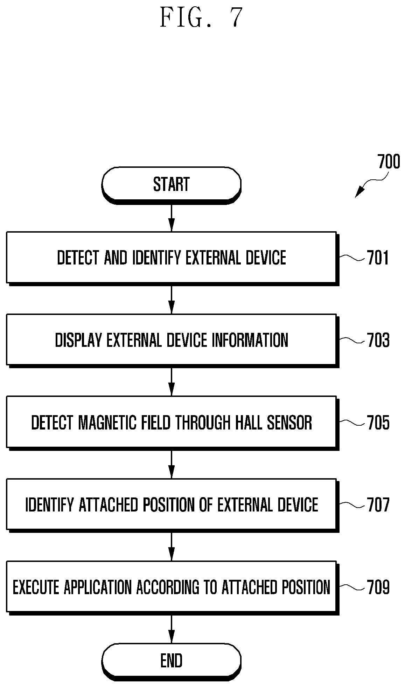

FIG. 7 is a flowchart 700 illustrating an operation method of an electronic device according to an embodiment.

Referring to FIG. 7, in operation 701, a processor (e.g., the processor 120 of FIG. 1) of an electronic device (e.g., the electronic device 101 of FIG. 1) according to an embodiment may detect and identify an external device (e.g., the external device 400 of FIG. 4A). According to an embodiment, the external device 400 may include at least one of a stand including a wireless charging pad, a vehicle cradle, a tripod mount, a lighting device, a photographic filter, or an electronic pen. This external device 400 may include multiple external magnetic bodies (or magnet modules) (e.g., the multiple magnetic bodies 401, 403, 405, and 407 of FIG. 4A) and an NFC tag (e.g., the NFC tag 409 of FIG. 4A). Alternatively, according to an embodiment, the external device 400 may further include a wireless charging coil (e.g., the wireless charging coil 419 of FIG. 4A) or at least one or more Hall sensors (e.g., the at least one or more Hall sensors 411 and 413 of FIG. 4A) (e.g., the sensor module 176 of FIG. 1).

The electronic device 101 may include multiple magnetic bodies (e.g., the multiple magnetic bodies 201 to 207 of FIG. 2A), at least one Hall sensor (e.g., the multiple Hall sensors 211 to 217 of FIG. 2A), a wireless charging coil (e.g., the wireless charging coil 219 of FIG. 2A), and an NFC antenna (e.g., the NFC antenna 209 of FIG. 2A). The processor 120 may detect tagging of the external device 400 by using the NFC antenna (e.g., the NFC antenna 209 of FIG. 2A). When the NFC tag 409 of the external device 400 corresponds to the NFC antenna 209, the processor 120 may detect tagging of the external device 400. The processor 120 may identify the external device 400 by reading tag information (or a tag value) of the external device 400. The tag information of the external device 400 may be stored in advance in the external device 400. The tag information may include device information of the external device 400. The device information of the external device 400 may include a name (or an identifier) or a type of the external device 400.

In operation 703, the processor 120 may display information of the external device 400. The processor 120 may notify a user, through a display (e.g., the display module 160 of FIG. 1), that the external device 400 is at least one of a stand capable of wireless charging, a vehicle cradle, a tripod mount, a lighting device, a photographic filter, or an electronic pen. The processor 120 may display information of the external device 400 while the external device 400 is attached.

In operation 705, the processor 120 may detect magnetic fields of multiple magnetic bodies 201 to 207 through a Hall sensor 213. The electronic device 101 may detect magnetic fields of the multiple magnetic bodies 201 to 207 by including two Hall sensors 211 and 213 or by using four Hall sensors 211 to 217. The multiple magnetic bodies 201 to 207 included in the electronic device 101 may be formed in a structure in which an outer S magnetic body radially surrounds such that S magnetism is oriented toward an inner N magnetic body. The multiple external magnetic bodies 401 to 407 included in the external device 400 may be formed in a structure in which an inner S magnetic body radially surrounds such that S magnetism is oriented toward an outer N magnetic body. When the multiple magnetic bodies 201 to 207 are tagged to the multiple external magnetic bodies 401 to 407 included in the external device 400, each Hall sensor may detect a change in an intensity and a wavelength of a magnetic field. Each Hall sensor may transmit the detected magnetic field change to the processor 120, or the processor 120 may read the magnetic field change detected by each Hall sensor. The processor 120 may detect magnetic fields of the multiple magnetic bodies 201 to 207 through the Hall sensor 213 while the external device 400 is attached.

In operation 707, the processor 120 may identify a position at which the external device 400 is attached. The attached position (or an attachment direction or a tagging mode) may indicate whether the external device 400 is attached to the electronic device 101 in the horizontal direction (or a lateral direction) or in the vertical direction (or a longitudinal direction). For example, when the electronic device 101 includes two Hall sensors 211 and 213, at least two magnetic bodies 401 and 407 of the external device 400 may generate a stronger magnetic field intensity than the remaining two magnets 403 and 405. This may be for identifying the attached position of the external device 400 by using the two Hall sensors 211 and 213. An example of identifying the attached position of the external device 400 by using the two Hall sensors 211 and 213 will be described in detail below with reference to the drawings. Alternatively, when the electronic device 101 includes four Hall sensors 211 to 217, the processor 120 may identify the attached position of the external device 400 based on magnetic field changes caused by the multiple magnetic bodies 201 to 207. The processor 120 may identify the attached position of the external device 400 while the external device 400 is attached.

In operation 709, the processor 120 may execute an application according to the attached position of the external device 400. For example, in case that the external device 400 is a wireless charging pad stand, the processor 120 may execute an application (or a pop-up or a notification) related to wireless charging when the external device 400 is attached to the electronic device 101 in the vertical direction, and the processor 120 may execute an application related to a video streaming service when the external device 400 is attached to the electronic device 101 in the horizontal direction. For example, in case that the external device 400 is a vehicle cradle, the processor 120 may execute a map application when the external device 400 is attached to the electronic device 101 in the vertical direction, and the processor 120 may execute an application related to a music streaming service when the external device 400 is attached to the electronic device 101 in the horizontal direction. The processor 120 may execute an application according to the attached position of the external device 400 while the external device 400 is attached.

According to an embodiment, after attaching the external device 400, the processor 120 may collect a usage history of the electronic device 101, and may execute an application differently according to the attached position of the external device 400 by further considering the collected usage history of the electronic device 101. A pattern of using the electronic device 101 after attaching the external device 400 may be different for each user. Based on the usage history of the electronic device 101, the processor 120 may execute an application that provides a function desired by a user such that the user may immediately perform the desired function without additional user input.

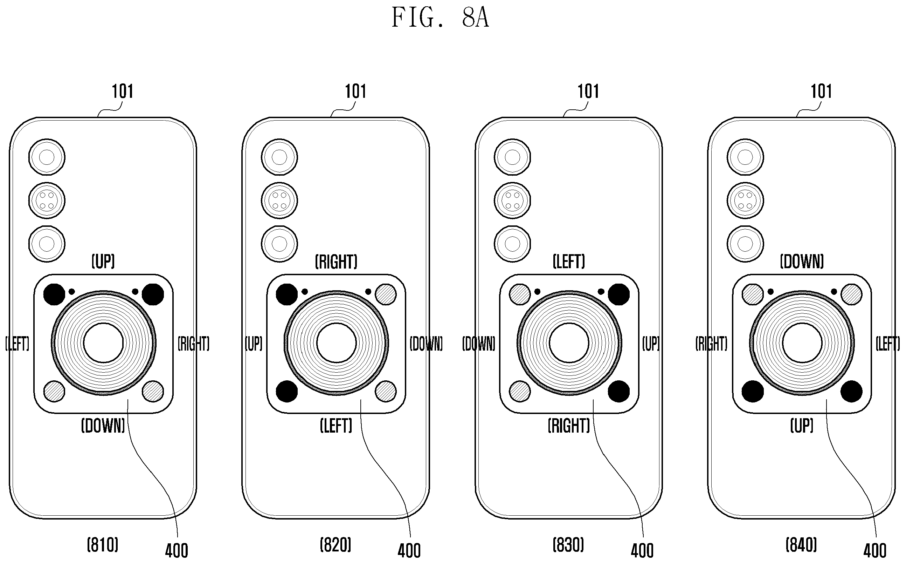

FIG. 8A illustrates an example in which an electronic device identifies an attached position of an external device, according to an embodiment.

Referring to FIG. 8A, when an electronic device (e.g., the electronic device 101 of FIG. 1) according to an embodiment includes four magnetic bodies (e.g., the four magnetic bodies 201 to 207 of FIG. 2A) and two Hall sensors (e.g., the first Hall sensor 211 and the second Hall sensor 213 of FIG. 2A) (e.g., the first embodiment 210 of FIG. 2A), at least two magnetic bodies (e.g., the first external magnetic body 401 and the fourth external magnetic body 407 of FIG. 4A) (shaded) of an external device (e.g., the external device 400 of FIG. 4A) may generate a stronger magnetic field intensity than the remaining two magnetic bodies (e.g., the second external magnetic body 403 and the third external magnetic body 405 of FIG. 4A).

A first attachment example 810 may indicate that the external device 400 is attached to the electronic device 101 in a first direction (e.g., a front side). A processor (e.g., the processor 120 of FIG. 1) of the electronic device 101 may detect a first magnetic field (e.g., a strong magnetic field) of the first external magnetic body 401 through the first Hall sensor 211, and may detect a first magnetic field of the fourth external magnetic body 407 through the second Hall sensor 213. Since strong (or high) magnetic fields are detected at both the first Hall sensor 211 and the second Hall sensor 213, the processor 120 may determine (or identify) that the external device 400 is attached in the first direction.

A second attachment example 820 may indicate that the external device 400 is attached to the electronic device 101 in a second direction. The processor 120 may detect a second magnetic field (e.g., a weak magnetic field) of the second external magnetic body 403 through the first Hall sensor 211, and may detect a first magnetic field of the first external magnetic body 401 through the second Hall sensor 213. Since a magnetic field detected at the first Hall sensor 211 is lower than a magnetic field detected at the second Hall sensor 213, the processor 120 may determine (or identify) that the external device 400 is attached in the second direction.

A third attachment example 830 may indicate that the external device 400 is attached to the electronic device 101 in a third direction. The processor 120 may detect a first magnetic field of the fourth external magnetic body 407 through the first Hall sensor 211, and may detect a second magnetic field of the third external magnetic body 405 through the second Hall sensor 213. Since a magnetic field detected at the first Hall sensor 211 is higher than a magnetic field detected at the second Hall sensor 213, the processor 120 may determine (or identify) that the external device 400 is attached in the third direction.

A fourth attachment example 840 may indicate that the external device 400 is attached to the electronic device 101 in a fourth direction. The processor 120 may detect a second magnetic field of the third external magnetic body 405 through the first Hall sensor 211, and may detect a second magnetic field of the second external magnetic body 403 through the second Hall sensor 213. Since weak (or low) magnetic fields are detected at both the first Hall sensor 211 and the second Hall sensor 213, the processor 120 may determine (or identify) that the external device 400 is attached in the fourth direction.

Accordingly, the processor 120 may identify an attached position (or an attachment direction) of the external device 400 based on magnetic field changes detected by the first Hall sensor 211 and the second Hall sensor 213.

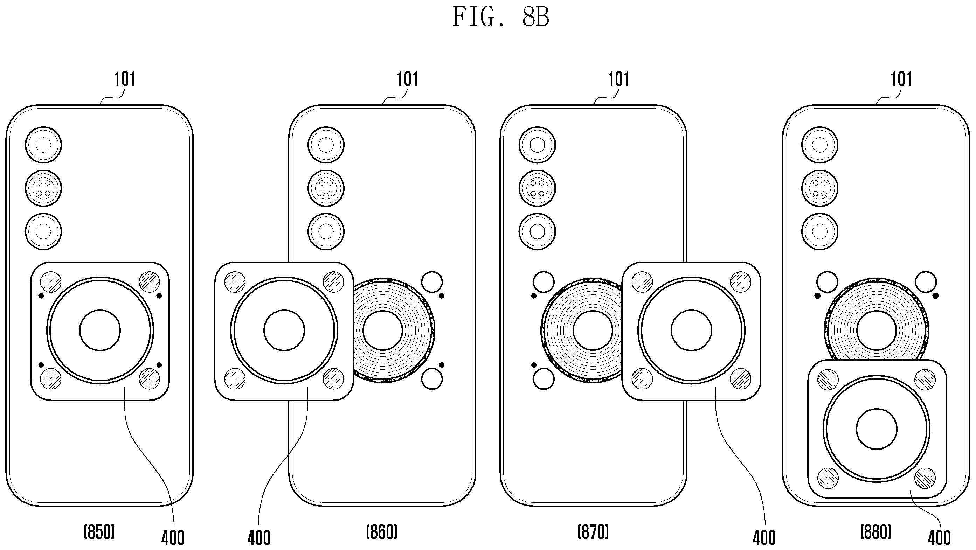

FIG. 8B illustrates an example in which an electronic device identifies an attachment location of an external device according to an embodiment.

Referring to FIG. 8B, the electronic device 101 may further include two Hall sensors (e.g., the third Hall sensor 215 and the fourth Hall sensor 217 of FIG. 2A), thereby including a total of four Hall sensors (e.g., the second embodiment 220 of FIG. 2A). In this case, four external magnetic bodies 401 to 407 included in the external device 400 may be formed with the same magnetic field intensity.

A fifth attachment example 850 may indicate that the external device 400 is attached to the electronic device 101 at a first attachment location (e.g., a central attachment location of the external device 400). The processor 120 may detect a magnetic field of a first external magnetic body 401 through a first Hall sensor 211, may detect a magnetic field of a fourth external magnetic body 407 through a second Hall sensor 213, may detect a magnetic field of a second external magnetic body 403 through a third Hall sensor 215, and may detect a magnetic field of a third external magnetic body 405 through a fourth Hall sensor 217. Since magnetic fields are detected at all of the first Hall sensor 211 to the fourth Hall sensor 217, the processor 120 may determine (or identify) that the external device 400 is attached at the first attachment location.

A sixth attachment example 860 may indicate that the external device 400 is attached to the electronic device 101 at a second attachment location (e.g., a left attachment location of the external device 400). The processor 120 may detect a magnetic field of a second external magnetic body 403 through the second Hall sensor 213, and may detect a magnetic field of a third external magnetic body 405 through the fourth Hall sensor 217. Since magnetic fields are detected at the second Hall sensor 213 and the fourth Hall sensor 217, the processor 120 may determine (or identify) that the external device 400 is attached at the second attachment location.

A seventh attachment example 870 may indicate that the external device 400 is attached to the electronic device 101 at a third attachment location (e.g., a right attachment location of the external device 400). The processor 120 may detect a magnetic field of a third external magnetic body 405 through the first Hall sensor 211, and may detect a magnetic field of a second external magnetic body 403 through the third Hall sensor 215. Since magnetic fields are detected at the first Hall sensor 211 and the third Hall sensor 215, the processor 120 may determine (or identify) that the external device 400 is attached at the third attachment location.

An eighth attachment example 880 may indicate that the external device 400 is attached to the electronic device 101 at a fourth attachment location (e.g., a lower-right attachment location of the external device 400 on the electronic device 101). The processor 120 may detect a magnetic field of a third external magnetic body 405 through the third Hall sensor 215, and may detect a magnetic field of a second external magnetic body 403 through the fourth Hall sensor 217. Since magnetic fields are detected at the third Hall sensor 215 and the fourth Hall sensor 217, the processor 120 may determine (or identify) that the external device 400 is attached at the fourth attachment location.

Accordingly, the processor 120 may identify an attachment location of the external device 400 based on magnetic field changes detected by at least one of the first Hall sensor 211 to the fourth Hall sensor 217.

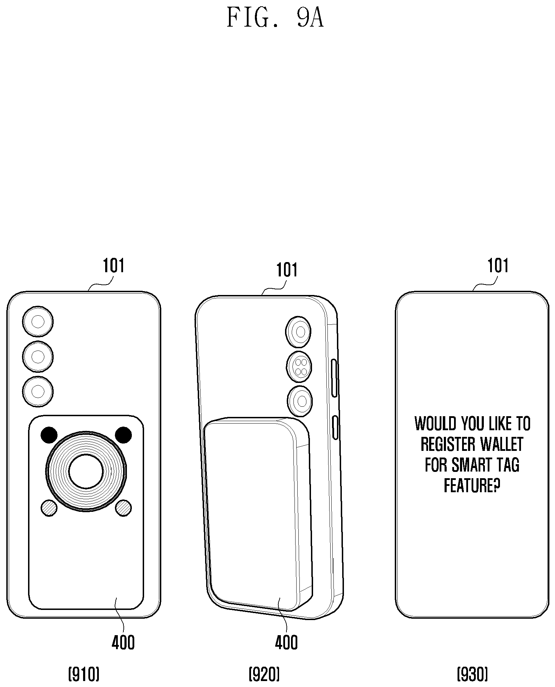

FIG. 9A illustrates an example in which an electronic device executes an application when an external device is tagged in the vertical direction, according to an embodiment.

Referring to FIG. 9A, as in a first drawing example 910, when an electronic device (e.g., the electronic device 101 of FIG. 1) according to an embodiment includes four magnetic bodies (e.g., the four magnetic bodies 201 to 207 of FIG. 2A) and two Hall sensors (e.g., the first Hall sensor 211 and the second Hall sensor 213 of FIG. 2A) (e.g., the first embodiment 210 of FIG. 2A), at least two magnetic bodies (e.g., the first external magnetic body 401 and the fourth external magnetic body 407 of FIG. 4A) (shaded) of an external device (e.g., the external device 400 of FIG. 4A) may generate a stronger magnetic field intensity than the remaining two magnetic bodies (e.g., the second external magnetic body 403 and the third external magnetic body 405 of FIG. 4A).

As in the first drawing example 910 and a first attachment example 920, the electronic device 101 may be tagged (or attached) to the external device 400 in the vertical direction. A processor (e.g., the processor 120 of FIG. 1) of the electronic device 101 may detect a first magnetic field (e.g., a strong magnetic field) of the first external magnetic body 401 through the first Hall sensor 211, and may detect a first magnetic field of the fourth external magnetic body 407 through the second Hall sensor 213. Since strong (or high) magnetic fields are detected at both the first Hall sensor 211 and the second Hall sensor 213, the processor 120 may determine that the external device 400 is attached in the vertical direction, and may provide a first user interface 930. When the external device 400 is a smart wallet, the first user interface 930 may include a guide for registering the wallet as a smart tag function.

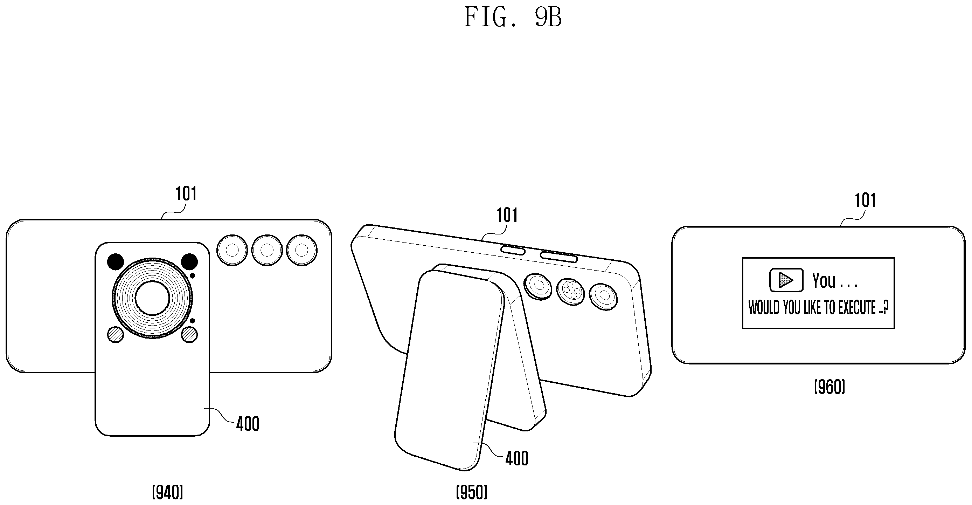

FIG. 9B illustrates an example in which an electronic device executes an application when an external device is tagged in the horizontal direction according to an embodiment.

Referring to FIG. 9B, as in a second drawing example 940, when the electronic device 101 includes four magnetic bodies 201 to 207, a first Hall sensor 211, and a second Hall sensor 213, at least two magnetic bodies (e.g., the first external magnetic body 401 and the fourth external magnetic body 407 of FIG. 4A) (shaded) of the external device 400 may generate a stronger magnetic field intensity than the remaining two magnetic bodies (e.g., the second external magnetic body 403 and the third external magnetic body 405 of FIG. 4A).

As in the second drawing example 940 and a second attachment example 950, the electronic device 101 may be tagged (or attached) to the external device 400 in the horizontal direction. The processor 120 may detect a second magnetic field (e.g., a weak magnetic field) of the second external magnetic body 403 through the first Hall sensor 211, and may detect a first magnetic field of the first external magnetic body 401 through the second Hall sensor 213. Since a magnetic field detected at the first Hall sensor 211 is lower than a magnetic field detected at the second Hall sensor 213, the processor 120 may determine that the external device 400 is attached in the horizontal direction, and may provide a second user interface 960. When the external device 400 is a wireless charging stand, the second user interface 960 may include an execution screen of an application most recently executed.

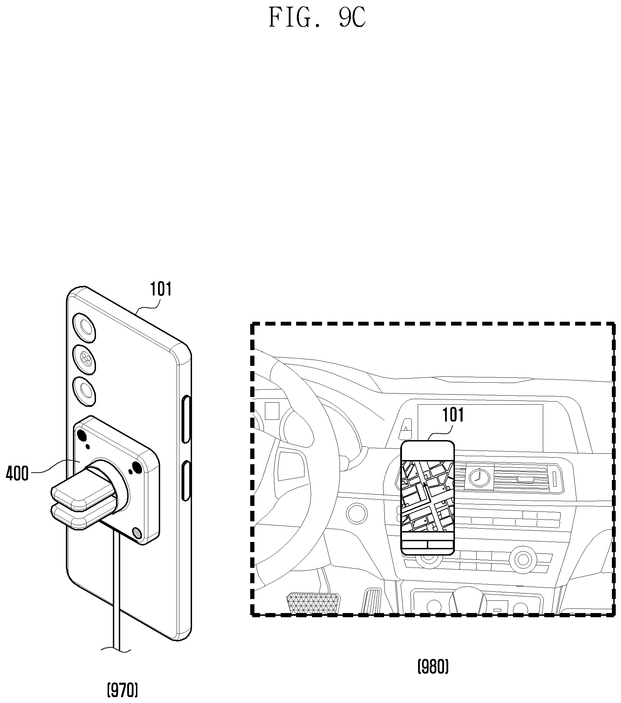

FIG. 9C illustrates another example in which an electronic device executes an application when an external device is tagged in the vertical direction, according to an embodiment.

Referring to FIG. 9C, as in a third attachment example 970, when the electronic device 101 includes four magnetic bodies 201 to 207, a first Hall sensor 211, and a second Hall sensor 213, at least two magnetic bodies (e.g., the first external magnetic body 401 and the fourth external magnetic body 407 of FIG. 4A) (shaded) of the external device 400 may generate a stronger magnetic field intensity than the remaining two magnetic bodies (e.g., the second external magnetic body 403 and the third external magnetic body 405 of FIG. 4A).

As in the third attachment example 970, the electronic device 101 may be tagged (or attached) to the external device 400 in the vertical direction. The processor 120 may detect a first magnetic field (e.g., a strong magnetic field) of the first external magnetic body 401 through the first Hall sensor 211, and may detect a first magnetic field of the fourth external magnetic body 407 through the second Hall sensor 213. Since strong (or high) magnetic fields are detected at both the first Hall sensor 211 and the second Hall sensor 213, the processor 120 may determine that the external device 400 is attached in the vertical direction, and may provide a third user interface 980. When the external device 400 is a vehicle cradle, the third user interface 980 may include an execution screen of a navigation (or map) application.

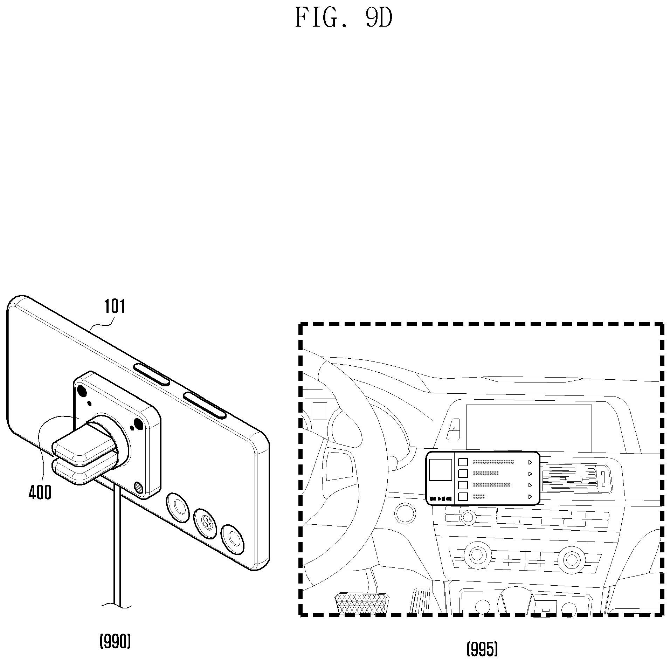

FIG. 9D illustrates another example in which an electronic device executes an application when an external device is tagged in the horizontal direction, according to an embodiment.

Referring to FIG. 9D, as in a fourth attachment example 990, when the electronic device 101 includes four magnetic bodies 201 to 207, a first Hall sensor 211, and a second Hall sensor 213, at least two magnetic bodies (e.g., the first external magnetic body 401 and the fourth external magnetic body 407 of FIG. 4A) (shaded) of the external device 400 may generate a stronger magnetic field intensity than the remaining two magnetic bodies (e.g., the second external magnetic body 403 and the third external magnetic body 405 of FIG. 4a).

As in the fourth attachment example 990, the electronic device 101 may be tagged (or attached) to the external device 400 in the horizontal direction. The processor 120 may detect a second magnetic field of the second external magnetic body 403 through the first Hall sensor 211, and may detect a first magnetic field of the first external magnetic body 401 through the second Hall sensor 213. Since a magnetic field detected at the first Hall sensor 211 is lower than a magnetic field detected at the second Hall sensor 213, the processor 120 may determine that the external device 400 is attached in the horizontal direction, and may provide a fourth user interface 995. When the external device 400 is a vehicle cradle, the fourth user interface 995 may include an execution screen of a music application.

According to an embodiment, after attaching the external device 400, the processor 120 may collect a usage history of the electronic device 101, and may execute an application other than the music application by further considering the collected usage history of the electronic device 101.

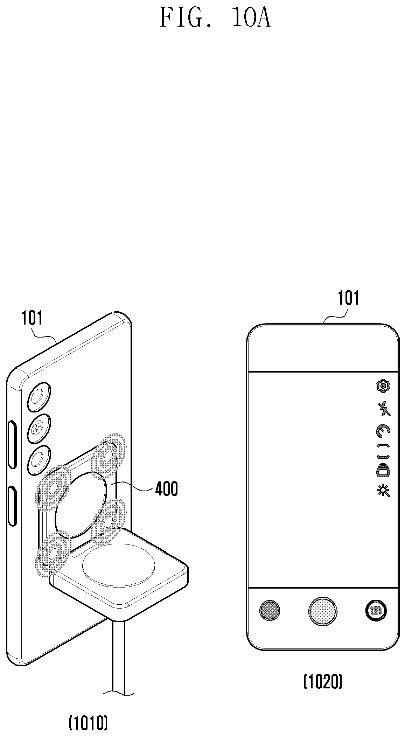

FIG. 10A illustrates an example in which an electronic device executes an application when an external device is tagged in the vertical direction, according to an embodiment.

Referring to FIG. 10A, as in a first attachment example 1010, when an electronic device (e.g., the electronic device 101 of FIG. 1) according to an embodiment includes four magnetic bodies (e.g., the four magnetic bodies 201 to 207 of FIG. 2A) and two Hall sensors (e.g., a first Hall sensor 211 and a second Hall sensor 213 of FIG. 2A) (e.g., the first embodiment 210 of FIG. 2A), at least two magnetic bodies (e.g., the first external magnetic body 401 and the fourth external magnetic body 407 of FIG. 4A) (shaded) of an external device (e.g., the external device 400 of FIG. 4A) may generate a stronger magnetic field intensity than the remaining two magnetic bodies (e.g., the second external magnetic body 403 and the third external magnetic body 405 of FIG. 4A).

As in the first attachment example 1010, the electronic device 101 may be tagged (or attached) to the external device 400 in the vertical direction. A processor (e.g., the processor 120 of FIG. 1) of the electronic device 101 may detect a first magnetic field (e.g., a strong magnetic field) of the first external magnetic body 401 through the first Hall sensor 211, and may detect a first magnetic field of the fourth external magnetic body 407 through the second Hall sensor 213. Since strong (or high) magnetic fields are detected at both the first Hall sensor 211 and the second Hall sensor 213, the processor 120 may determine that the external device 400 is attached in the vertical direction, and may provide a first user interface 1020. When the external device 400 is a tripod mount, the first user interface 1020 may include an execution screen of a camera application for capturing images in a selfie mode. The processor 120 may activate a camera disposed on the front surface of the electronic device 101 and execute the camera application to provide the first user interface 1020.

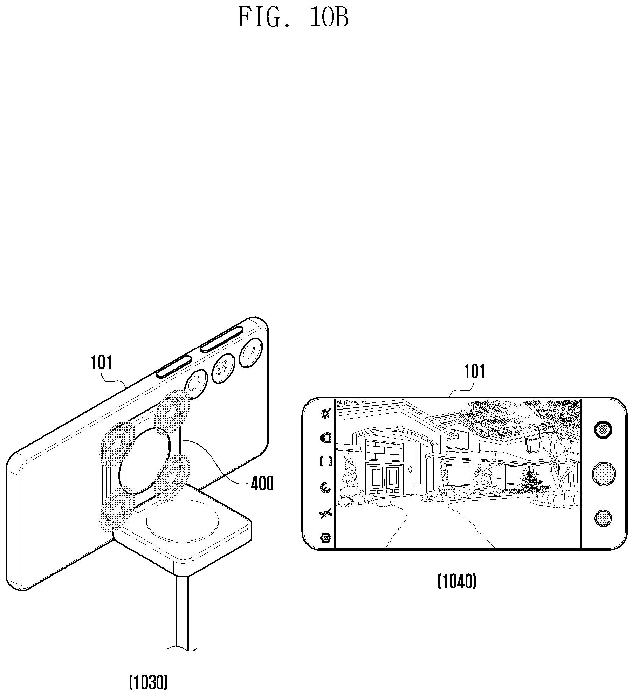

FIG. 10B illustrates an example in which an electronic device executes an application when an external device is tagged in the horizontal direction, according to an embodiment.

Referring to FIG. 10B, as in a second attachment example 1030, when the electronic device 101 includes four magnetic bodies 201 to 207, a first Hall sensor 211, and a second Hall sensor 213, at least two magnetic bodies (e.g., the first external magnetic body 401 and the fourth external magnetic body 407 of FIG. 4A) (shaded) of the external device 400 may generate a stronger magnetic field intensity than the remaining two magnetic bodies (e.g., the second external magnetic body 403 and the third external magnetic body 405 of FIG. 4A).

As in the second attachment example 1030, the electronic device 101 may be tagged (or attached) to the external device 400 in the horizontal direction. The processor 120 may detect a second magnetic field of the second external magnetic body 403 through the first Hall sensor 211, and may detect a first magnetic field of the first external magnetic body 401 through the second Hall sensor 213. Since a magnetic field detected at the first Hall sensor 211 is lower than a magnetic field detected at the second Hall sensor 213, the processor 120 may determine that the external device 400 is attached in the horizontal direction, and may provide a second user interface 1040. When the external device 400 is a tripod mount, the second user interface 1040 may include an execution screen of a camera application for capturing images in a designated mode (e.g., a landscape shooting mode) (or a recently used shooting mode). The processor 120 may activate a camera disposed on the rear surface of the electronic device 101 and execute the camera application to provide the second user interface 1040. The processor 120 may also provide, through the second user interface 1040, a pop-up for capturing images in the landscape shooting mode.

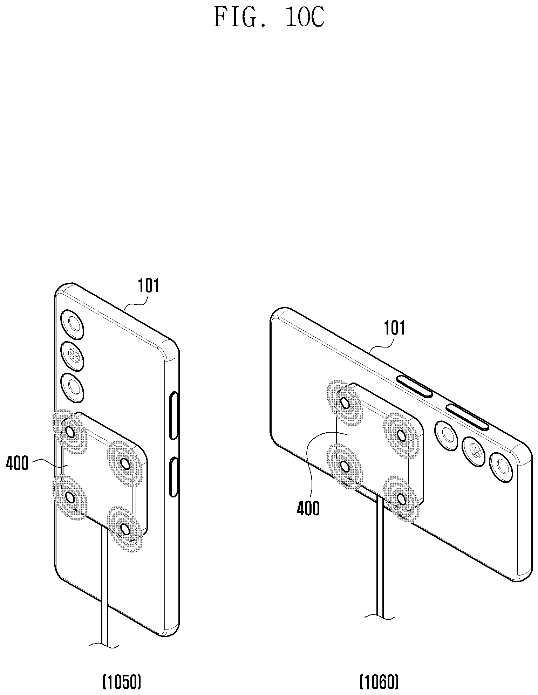

FIG. 10C illustrates an example in which an electronic device executes an application differently according to an attached position of an external device, according to an embodiment.

Referring to FIG. 10C, as in a third attachment example 1050 or a fourth attachment example 1060, when the electronic device 101 includes four magnetic bodies 201 to 207, a first Hall sensor 211, and a second Hall sensor 213, at least two magnetic bodies (e.g., the first external magnetic body 401 and the fourth external magnetic body 407 of FIG. 4A) (shaded) of the external device 400 may generate a stronger magnetic field intensity than the remaining two magnetic bodies (e.g., the second external magnetic body 403 and the third external magnetic body 405 of FIG. 4A).

As in the third attachment example 1050, the electronic device 101 may be tagged (or attached) to the external device 400 in the vertical direction. The processor 120 may detect a first magnetic field of the first external magnetic body 401 through the first Hall sensor 211, and may detect a first magnetic field of the fourth external magnetic body 407 through the second Hall sensor 213. Since strong (or high) magnetic fields are detected at both the first Hall sensor 211 and the second Hall sensor 213, the processor 120 may determine that the external device 400 is attached in the vertical direction. When the external device 400 is a wireless charging stand and is attached in the vertical direction, the processor 120 may execute a first designated application.

As in the fourth attachment example 1060, the electronic device 101 may be tagged (or attached) to the external device 400 in the horizontal direction. The processor 120 may detect a second magnetic field of the second external magnetic body 403 through the first Hall sensor 211, and may detect a first magnetic field of the first external magnetic body 401 through the second Hall sensor 213. Since a magnetic field detected at the first Hall sensor 211 is lower than a magnetic field detected at the second Hall sensor 213, the processor 120 may determine that the external device 400 is attached in the horizontal direction. When the external device 400 is a wireless charging stand and is attached in the horizontal direction, the processor 120 may execute a second designated application.

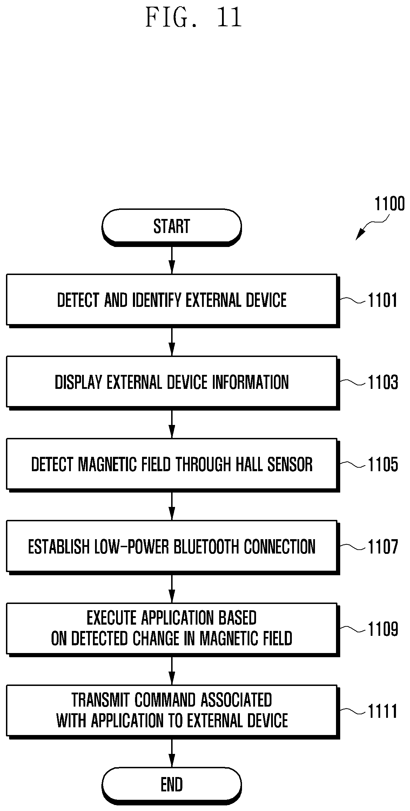

FIG. 11 is a flowchart illustrating a method for executing an application by an electronic device according to an attachment location of an external device, according to an embodiment.

Referring to FIG. 11, in operation 1101, a processor (e.g., the processor 120 of FIG. 1) of an electronic device (e.g., the electronic device 101 of FIG. 1) according to an embodiment may detect and identify an external device (e.g., the external device 400 of FIG. 4A). According to an embodiment, the external device 400 may include at least one of a stand including a wireless charging pad, a vehicle cradle, a tripod mount, a lighting device, a photographic filter, or an electronic pen. The external device 400 may include multiple external magnetic bodies (or magnet modules) (e.g., the multiple magnetic bodies 401, 403, 405, and 407 of FIG. 4A) and an NFC tag (e.g., the NFC tag 409 of FIG. 4A). Alternatively, according to an embodiment, the external device 400 may further include a wireless charging coil (e.g., the wireless charging coil 419 of FIG. 4A) or at least one Hall sensor (e.g., the at least one Hall sensor 411 and 413 of FIG. 4A) (e.g., the sensor module 176 of FIG. 1).

The electronic device 101 may include multiple magnetic bodies (e.g., the multiple magnetic bodies 201 to 207 of FIG. 2A), at least one Hall sensor (e.g., the multiple Hall sensors 211 to 217 of FIG. 2A), a wireless charging coil (e.g., the wireless charging coil 219 of FIG. 2A), and an NFC antenna (e.g., the NFC antenna 209 of FIG. 2A). The processor 120 may detect tagging of the external device 400 using an NFC antenna (e.g., the NFC antenna 209 of FIG. 2A). When the NFC tag 409 of the external device 400 corresponds to the NFC antenna 209, the processor 120 may detect tagging of the external device 400. The processor 120 may identify the external device 400 by reading tag information (or a tag value) of the external device 400. The tag information of the external device 400 may be stored in advance in the external device 400. The tag information may include device information of the external device 400. The device information of the external device 400 may include a name (or identifier) or a type of the external device 400.

In operation 1103, the processor 120 may display information of the external device 400. The processor 120 may inform a user, through a display (e.g., the display module 160 of FIG. 1), that the external device 400 is at least one of a stand capable of wireless charging, a vehicle cradle, a tripod mount, a lighting device, a photographic filter, or an electronic pen.

In operation 1105, the processor 120 may detect magnetic fields of the multiple magnetic bodies 201 to 207 through a Hall sensor 213. The electronic device 101 may include two Hall sensors 211 and 213, or may detect magnetic fields of the multiple magnetic bodies 201 to 207 using four Hall sensors 211 to 217. The multiple magnetic bodies 201 to 207 included in the electronic device 101 may be formed in a structure in which an outer S magnetic body radially surrounds such that S magnetism is directed toward an inner N magnetic body. The multiple external magnetic bodies 401 to 407 included in the external device 400 may be formed in a structure in which an inner S magnetic body radially surrounds such that S magnetism is directed toward an outer N magnetic body. Each Hall sensor may detect a change in magnetic field intensity and wavelength when the multiple magnetic bodies 201 to 207 are tagged to the multiple external magnetic bodies 401 to 407 included in the external device 400. Each Hall sensor may transmit the detected magnetic field change to the processor 120, or the processor 120 may read the magnetic field change detected by each Hall sensor.

In operation 1107, the processor 120 may establish a low-power Bluetooth connection with the external device 400. When the external device 400 is detected, the processor 120 may establish a low-power Bluetooth connection with the external device 400 through a low-power Bluetooth communication module (e.g., the communication module 190 of FIG. 1). Although FIG. 11 illustrates that operation 1107 is performed after operation 1105, operations 1105 and 1107 may be performed in parallel (e.g., simultaneously), or operation 1107 may be performed before operation 1105. This is merely an example, and the disclosure is not limited thereto.

In operation 1109, the processor 120 may execute an application based on the detected magnetic field change. The processor 120 may identify an attached position of the external device 400 or an attachment location of the external device 400 based on the detected magnetic field change. The attached position (or attachment direction, tagging mode) may indicate whether the external device 400 is tagged to the electronic device 101 in the horizontal direction (or the lateral direction) or in the vertical direction (or the longitudinal direction). Alternatively, the attachment location may indicate whether the external device 400 is tagged at the center, the right side, the left side, or the lower side of the electronic device 101.

According to an embodiment, when the electronic device 101 includes two Hall sensors 211 and 213, at least two magnetic bodies 401 and 407 of the external device 400 may generate a stronger magnetic field intensity than the remaining two magnetic bodies 403 and 405. Alternatively, when the electronic device 101 includes four Hall sensors 211 to 217, the processor 120 may identify the attachment location of the external device 400 based on the magnetic field changes caused by the multiple magnetic bodies 201 to 207.

For example, in case that the external device 400 is a lighting device, the processor 120 may execute a camera application in a designated mode when the external device 400 is attached at the center of the electronic device 101, and the processor 120 may execute a camera application in a selfie mode when the external device 400 is attached at the right side of the electronic device 101.

In operation 1111, the processor 120 may transmit a command (or an instruction) associated with the executed application to the external device 400. The processor 120 may transmit, via low-power Bluetooth, a command to start wireless charging or to turn on a light source to the external device 400. The external device 400 may receive the command from the electronic device 101 and start wireless charging or turn on the light source.

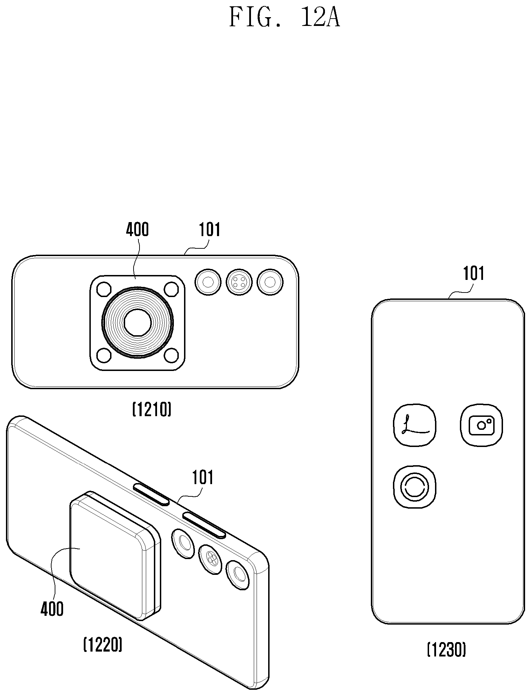

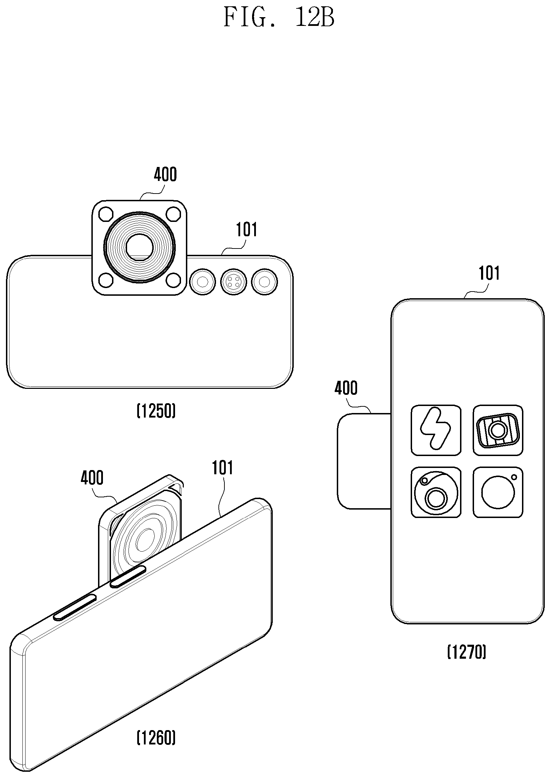

FIGS. 12A and 12B each illustrate an example in which an electronic device executes an application according to an attachment location of an external device, according to an embodiment.

Referring to FIG. 12A, as in a first drawing example 1210, an electronic device (e.g., the electronic device 101 of FIG. 1) according to an embodiment may include four magnetic bodies (e.g., the four magnetic bodies 201 to 207 of FIG. 2A) and four Hall sensors (e.g., the four Hall sensors 211 to 213 of FIG. 2A) (e.g., the second embodiment 220 of FIG. 2A).

The first drawing example 1210 and a first attachment example 1220 may indicate that an external device 400 is attached to the electronic device 101 at the first attachment location (e.g., a central attachment location of the external device 400). A processor (e.g., the processor 120 of FIG. 1) of the electronic device 101 may detect a magnetic field of a first external magnetic body 401 through a first Hall sensor 211, may detect a magnetic field of a fourth external magnetic body 407 through a second Hall sensor 213, may detect a magnetic field of a second external magnetic body 403 through a third Hall sensor 215, and may detect a magnetic field of a third external magnetic body 405 through a fourth Hall sensor 217. Since magnetic fields are detected at all of the first Hall sensor 211 to the fourth Hall sensor 217, the processor 120 may determine (or identify) that the external device 400 is attached at the first attachment location. When the external device 400, which is a lighting device, is attached at the first attachment location, the processor 120 may provide a first user interface 1230. The first user interface 1230 may include an execution screen (e.g., a preview image of the rear camera) of a camera application resulting from activation of a rear camera of the electronic device 101. While transmitting a command to turn on a light source to the external device 400, the processor 120 may display the first user interface 1230 on a display (e.g., the display module 160 of FIG. 1). The external device 400 may turn on the light source based on the command received from the electronic device 101.

Referring to FIG. 12B, as in a second drawing example 1250 and a second attachment example 1260, the electronic device 101 may include four magnetic bodies 201 to 207 and four Hall sensors 211 to 217 (e.g., the second embodiment 220 of FIG. 2A).

The second drawing example 1250 and the second attachment example 1260 may indicate that the external device 400 is attached to the electronic device 101 at a second attachment location (e.g., the left-side attachment location of the external device 400). The processor 120 may detect a magnetic field of a second external magnetic body 403 through the second Hall sensor 213, and may detect a magnetic field of a third external magnetic body 405 through the fourth Hall sensor 217. Since magnetic fields are detected at the second Hall sensor 213 and the fourth Hall sensor 217, the processor 120 may determine (or identify) that the external device 400 is attached at the second attachment location. When the external device 400, which is a lighting device, is attached at the second attachment location, the processor 120 may provide a second user interface 1270. The second user interface 1270 may include an execution screen (e.g., a preview image of the front camera) of a camera application resulting from activation of the front camera of the electronic device 101 (e.g., a selfie mode). While transmitting a command to turn on a light source to the external device 400, the processor 120 may display the second user interface 1270 on the display module 160. The external device 400 may turn on the light source based on the command received from the electronic device 101.

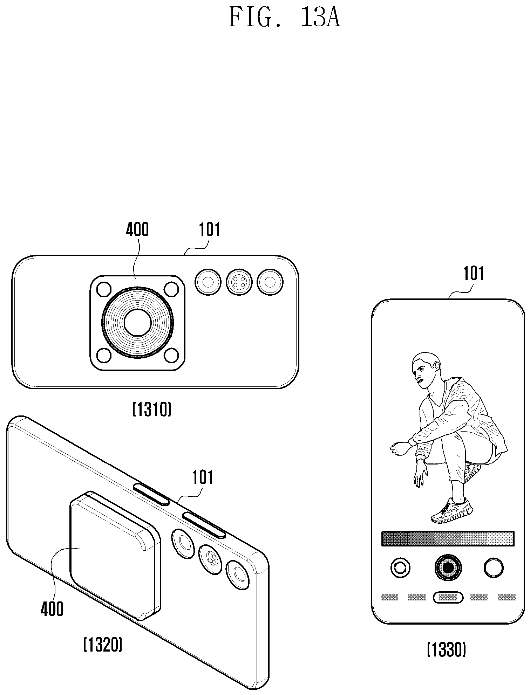

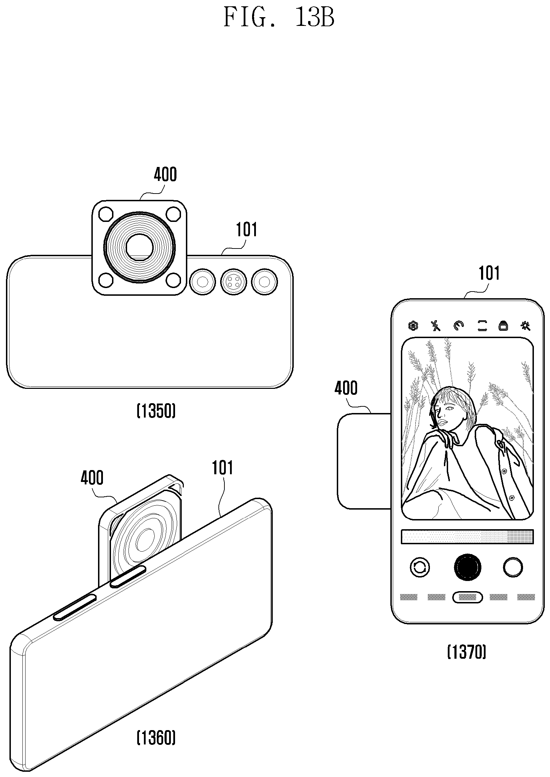

FIGS. 13A and 13B each illustrate another example in which an electronic device executes an application according to an attachment position of an external device, according to an embodiment.

Referring to FIG. 13A, as in a first drawing example 1310, an electronic device (e.g., the electronic device 101 of FIG. 1) according to an embodiment may include four magnetic bodies (e.g., the four magnetic bodies 201 to 207 of FIG. 2A) and four Hall sensors (e.g., the four Hall sensors 211 to 213 of FIG. 2A) (e.g., the second embodiment 220 of FIG. 2A).

The first drawing example 1310 and a first attachment example 1320 may indicate that the external device 400 is attached to the electronic device 101 at the first attachment location (e.g., the central attachment location of the external device 400). A processor (e.g., the processor 120 of FIG. 1) of the electronic device 101 may detect a magnetic field of a first external magnetic body 401 through a first Hall sensor 211, may detect a magnetic field of a fourth external magnetic body 407 through a second Hall sensor 213, may detect a magnetic field of a second external magnetic body 403 through a third Hall sensor 215, and may detect a magnetic field of a third external magnetic body 405 through a fourth Hall sensor 217. Since magnetic fields are detected at all of the first Hall sensor 211 to the fourth Hall sensor 217, the processor 120 may determine (or identify) that the external device 400 is attached at the first attachment location. When the external device 400, which is a lighting device, is attached at the first attachment location, the processor 120 may provide a first user interface 1330. The first user interface 1330 may include an execution screen (e.g., a preview image of the rear camera) of a camera application resulting from activation of a rear camera of the electronic device 101. While transmitting a command to turn on a light source to the external device 400, the processor 120 may display the first user interface 1330 on a display (e.g., the display module 160 of FIG. 1). The external device 400 may turn on the light source based on the command received from the electronic device 101.

Referring to FIG. 13B, as in a second drawing example 1350 and a second attachment example 1360, the electronic device 101 may include four magnetic bodies 201 to 207 and four Hall sensors 211 to 213 (e.g., the second embodiment 220 of FIG. 2A).

The second drawing example 1350 and the second attachment example 1360 may indicate that the external device 400 is attached to the electronic device 101 at the second attachment location (e.g., the left-side attachment location of the external device 400). The processor 120 may detect a magnetic field of a second external magnetic body 403 through the second Hall sensor 213, and may detect a magnetic field of a third external magnetic body 405 through the fourth Hall sensor 217. Since magnetic fields are detected at the second Hall sensor 213 and the fourth Hall sensor 217, the processor 120 may determine (or identify) that the external device 400 is attached at the second attachment location. When the external device 400, which is a lighting device, is attached at the second attachment location, the processor 120 may provide a second user interface 1370. The second user interface 1370 may include an execution screen (e.g., a preview image of the front camera) of a camera application resulting from activation of the front camera of the electronic device 101 (e.g., a selfie mode). While transmitting a command to turn on a light source to the external device 400, the processor 120 may display the second user interface 1370 on the display module 160. The external device 400 may turn on the light source based on the command received from the electronic device 101.

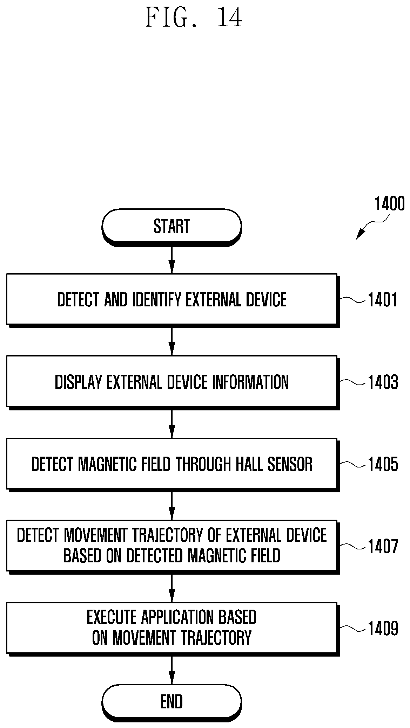

FIG. 14 is a flowchart 1400 illustrating a method for executing an application by an electronic device according to a movement trajectory of an external device, according to an embodiment.

Referring to FIG. 14, in operation 1401, a processor (e.g., the processor 120 of FIG. 1) of an electronic device (e.g., the electronic device 101 of FIG. 1) according to an embodiment may detect and identify an external device (e.g., the external device 400 of FIG. 4A). According to an embodiment, the external device 400 may include at least one of a stand including a wireless charging pad, a vehicle cradle, a tripod mount, a lighting device, a photographic filter, or an electronic pen. The external device 400 may include multiple external magnetic bodies (or magnet modules) (e.g., the multiple magnetic bodies 401, 403, 405, and 407 of FIG. 4A) and an NFC tag (e.g., the NFC tag 409 of FIG. 4A). Alternatively, according to an embodiment, the external device 400 may further include a wireless charging coil (e.g., the wireless charging coil 419 of FIG. 4A) or at least one Hall sensor (e.g., the at least one Hall sensor 411 and 413 of FIG. 4A) (e.g., the sensor module 176 of FIG. 1).

The electronic device 101 may include multiple magnetic bodies (e.g., the multiple magnetic bodies 201 to 207 of FIG. 2A), at least one Hall sensor (e.g., the multiple Hall sensors 211 to 217 of FIG. 2A), a wireless charging coil (e.g., the wireless charging coil 219 of FIG. 2A), and an NFC antenna (e.g., the NFC antenna 209 of FIG. 2A). The processor 120 may detect tagging of the external device 400 using the NFC antenna 209. When the NFC tag 409 of the external device 400 corresponds to the NFC antenna 209, the processor 120 may detect tagging of the external device 400. The processor 120 may identify the external device 400 by reading tag information (or a tag value) of the external device 400. The tag information of the external device 400 may be stored in advance in the external device 400. The tag information may include device information of the external device 400. The device information of the external device 400 may include a name (or identifier) or a type of the external device 400.

In operation 1403, the processor 120 may display information of the external device 400. The processor 120 may inform a user, through a display (e.g., the display module 160 of FIG. 1), that the external device 400 is at least one of a stand capable of wireless charging, a vehicle cradle, a tripod mount, a lighting device, a photographic filter, or an electronic pen.

In operation 1405, the processor 120 may detect magnetic fields of the multiple magnetic bodies 201 to 207 through a Hall sensor 213. The electronic device 101 may include two Hall sensors 211 and 213, or may detect magnetic fields of the multiple magnetic bodies 201 to 207 using four Hall sensors 211 to 217. The multiple magnetic bodies 201 to 207 included in the electronic device 101 may be formed in a structure in which an outer S magnetic body radially surrounds such that S magnetism is directed toward an inner N magnetic body. The multiple external magnetic bodies 401 to 407 included in the external device 400 may be formed in a structure in which an inner S magnetic body radially surrounds such that S magnetism is directed toward an outer N magnetic body. Each Hall sensor may detect a change in magnetic field intensity and wavelength when the multiple magnetic bodies 201 to 207 are tagged to the multiple external magnetic bodies 401 to 407 included in the external device 400. Each Hall sensor may transmit the detected magnetic field change to the processor 120, or the processor 120 may read the magnetic field change detected by each Hall sensor.

In operation 1407, the processor 120 may detect a movement trajectory of the external device 400 based on the detected magnetic field change. For example, magnetic field may initially be detected at all four Hall sensors 211 to 217, and thereafter magnetic field may be detected at only at least one of the second Hall sensor 213, the third Hall sensor 215, or the fourth Hall sensor 217.

In operation 1409, the processor 120 may execute an application based on the movement trajectory of the external device 400. For example, when a movement trajectory of the external device 400 is detected while a first function of an application (e.g., landscape photography) is executed, the processor 120 may execute (or switch to) a second function of the application (e.g., a selfie mode).

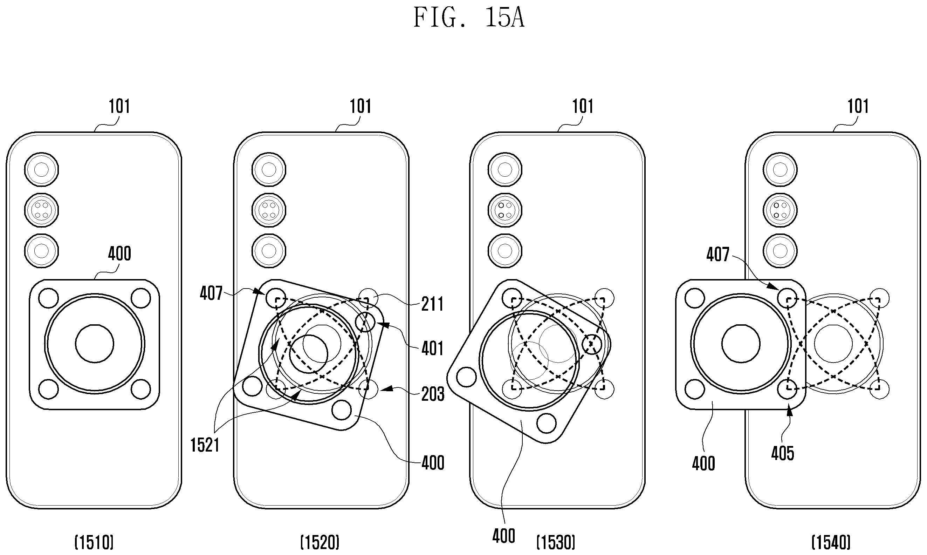

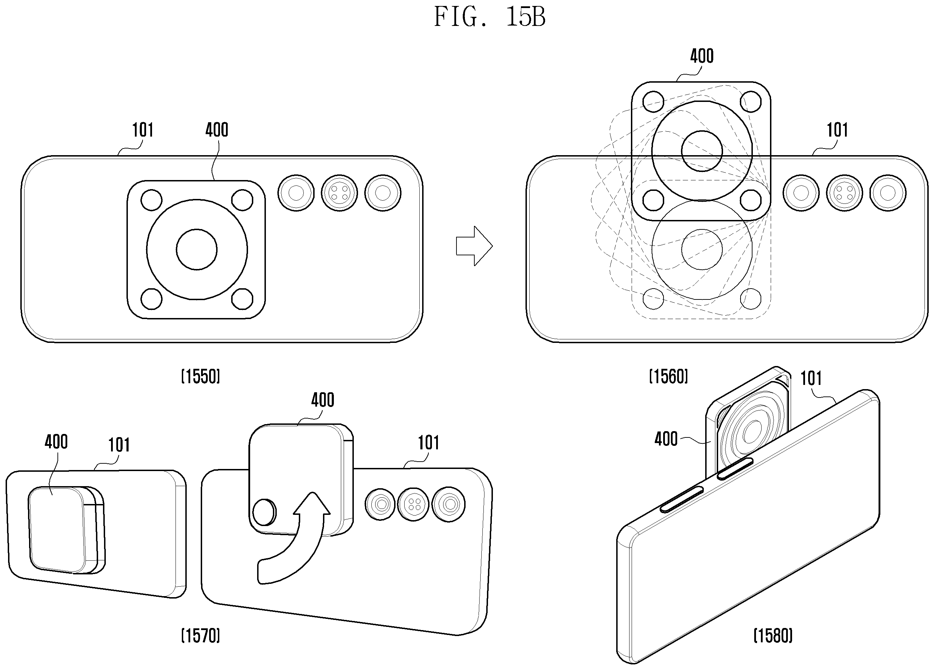

FIGS. 15A and 15B each illustrate an example in which an electronic device executes an application according to a movement trajectory of an external device, according to an embodiment.

Referring to FIG. 15A, as in a first attachment example 1510, an electronic device (e.g., the electronic device 101 of FIG. 1) according to an embodiment may include four magnetic bodies (e.g., the four magnetic bodies 201 to 207 of FIG. 2A) and four Hall sensors (e.g., the four Hall sensors 211 to 213 of FIG. 2A) (e.g., the second embodiment 220 of FIG. 2A). The first attachment example 1510 may indicate that an external device (e.g., the external device 400 of FIG. 4A) is attached to the electronic device 101 at the first attachment location (e.g., a central attachment location of the external device 400). A processor (e.g., the processor 120 of FIG. 1) of the electronic device 101 may detect a magnetic field of a first external magnetic body 401 through a first Hall sensor 211, may detect a magnetic field of a fourth external magnetic body 407 through a second Hall sensor 213, may detect a magnetic field of a second external magnetic body 403 through a third Hall sensor 215, and may detect a magnetic field of a third external magnetic body 405 through a fourth Hall sensor 217. Since magnetic fields are detected at all of the first Hall sensor 211 to the fourth Hall sensor 217, the processor 120 may determine (or identify) that the external device 400 is attached at the first attachment location.

Thereafter, the processor 120 may detect a first movement trajectory 1520 based on magnetic field changes detected by the four Hall sensors 211 to 213. In the first movement trajectory 1520, the processor 120 may fail to detect magnetic fields at the first Hall sensor 211, the third Hall sensor 215, and the fourth Hall sensor 217, and may detect a magnetic field of the fourth external magnetic body 407 through the second Hall sensor 213. Alternatively, the processor 120 may detect, at the second Hall sensor 213, a magnetic field stronger than magnetic fields detected at the first Hall sensor 211, the third Hall sensor 215, and the fourth Hall sensor 217. In this case, the processor 120 may detect a movement trajectory change 1521 with respect to the fourth external magnetic body 407 of the external device 400.

Subsequently, the processor 120 may detect a second movement trajectory 1530 based on magnetic field changes detected by the four Hall sensors 211 to 213. In the second movement trajectory 1530, the processor 120 may fail to detect magnetic fields at the first Hall sensor 211, the third Hall sensor 215, and the fourth Hall sensor 217, and may detect a magnetic field of the fourth external magnetic body 407 through the second Hall sensor 213. Alternatively, the processor 120 may detect, at the second Hall sensor 213, a magnetic field stronger than magnetic fields detected at the first Hall sensor 211, the third Hall sensor 215, and the fourth Hall sensor 217.

As the movement continues, the external device 400 may be attached to the electronic device 101 at the second attachment location (e.g., the left-side attachment location of the external device 400), as in a second attachment example 1540. The processor 120 may detect a magnetic field of a second external magnetic body 403 through the second Hall sensor 213, and may detect a magnetic field of a third external magnetic body 405 through the fourth Hall sensor 217. Since magnetic fields are detected at the second Hall sensor 213 and the fourth Hall sensor 217, the processor 120 may determine (or identify) that the external device 400 is attached at the second attachment location. When the external device 400, which is a lighting device, is attached at the second attachment location, the processor 120 may execute a second function of an application (e.g., a selfie mode). The processor 120 may display a first execution screen (e.g., a preview image of a rear camera) of a camera application in the first attachment example 1510, and may display a second execution screen (e.g., a preview image of a front camera) of the camera application in the second attachment example 1540.

Referring to FIG. 15B, a third attachment example 1550 may indicate that the external device 400 is attached to the electronic device 101 at the first attachment location (e.g., a central attachment location of the external device 400). The processor 120 may detect a magnetic field of the first external magnetic body 401 through the first Hall sensor 211, may detect a magnetic field of the fourth external magnetic body 407 through the second Hall sensor 213, may detect a magnetic field of the second external magnetic body 403 through the third Hall sensor 215, and may detect a magnetic field of the third external magnetic body 405 through the fourth Hall sensor 217. Since magnetic fields are detected at all of the first Hall sensor 211 to the fourth Hall sensor 217, the processor 120 may determine (or identify) that the external device 400 is attached at the first attachment location.

Thereafter, the processor 120 may detect a movement trajectory of the external device 400 based on magnetic field changes detected by the four Hall sensors 211 to 213. Based on the movement trajectory of the external device 400, the processor 120 may detect that the external device 400 is attached to the electronic device 101 at the second attachment location 1570.

When the external device 400 is attached at the second attachment location 1570, the processor 120 may execute a second function 1580 of an application. For example, the external device 400 may be a lighting device, a speaker, a microphone for video recording, or a front recognition sensor. The processor 120 may display a first execution screen (e.g., a preview image of a rear camera) of a camera application in the third attachment example 1550, and may display a second execution screen (e.g., a preview image of a front camera) of the camera application in the fourth attachment example 1580.

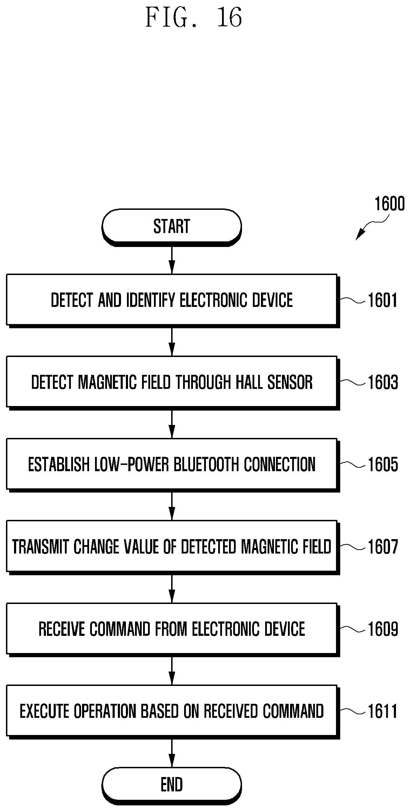

FIG. 16 is a flowchart illustrating an operation method of an external device according to an embodiment.

Referring to FIG. 16, in operation 1601, a processor (e.g., the processor 120 of FIG. 1) of an external device (e.g., the external device 400 of FIG. 4A) according to an embodiment may detect and identify an electronic device 101. According to an embodiment, the external device 400 may include at least one of a stand including a wireless charging pad, a vehicle cradle, a tripod mount, a lighting device, a photographic filter, or an electronic pen. This external device 400 may include multiple external magnetic bodies (or magnet modules) (e.g., the multiple magnetic bodies 401, 403, 405, and 407 of FIG. 4A), at least one Hall sensor (e.g., the at least one Hall sensor 411 or 413 of FIG. 4A (e.g., the sensor module 176 of FIG. 1)), and an NFC tag (e.g., the NFC tag 409 of FIG. 4A). In FIG. 16, the electronic device 101 may include multiple magnetic bodies (e.g., the multiple magnetic bodies 201 to 207 of FIG. 2A), a wireless charging coil (e.g., the wireless charging coil 219 of FIG. 2A), and an NFC antenna (e.g., the NFC antenna 209 of FIG. 2A). That is, in the embodiment of FIG. 16, the electronic device 101 does not detect tagging of the external device 400, and the external device 400 detects tagging of the electronic device 101. Accordingly, the electronic device 101 may not include a Hall sensor.

In operation 1603, the processor 120 may detect magnetic fields of the multiple magnetic bodies 401, 403, 405, and 407 through at least one Hall sensor. The multiple magnetic bodies 201 to 207 included in the electronic device 101 may be formed in a structure in which outer S magnetic bodies radially surround inner N magnetic bodies such that S polarity faces toward the inner N magnetic bodies. The multiple external magnetic bodies 401 to 407 included in the external device 400 may be formed in a structure in which inner S magnetic bodies radially surround outer N magnetic bodies such that S polarity faces toward the outer N magnetic bodies. Each Hall sensor may detect a change in magnetic field intensity and waveform when the multiple magnetic bodies 201 to 207 are tagged to the multiple external magnetic bodies 401 to 407 included in the external device 400. Each Hall sensor may transmit the detected magnetic field change to the processor 120. Alternatively, the processor 120 may read the magnetic field change detected by each Hall sensor.

In operation 1605, the processor 120 may establish a low-power Bluetooth connection with the external device 400. When the electronic device 101 is detected, the processor 120 may connect to the external device 400 via low-power Bluetooth through a low-power Bluetooth communication module (e.g., the communication module 190 of FIG. 1). Although FIG. 16 illustrates that operation 1605 is performed after operation 1603, operations 1603 and 1605 may be performed in parallel (e.g., simultaneously), or operation 1605 may be performed before operation 1603. This is merely an example, and the disclosure is not limited thereto.

In operation 1607, the processor 120 may transmit the detected magnetic field change values. In the embodiment of FIG. 16, since the electronic device 101 does not detect tagging of the external device 400 and the external device 400 detects tagging of the electronic device 101, the external device 400 may transmit the magnetic field change values to the electronic device 101. The processor 120 may transmit the detected magnetic field change values to the electronic device 101 through the low-power Bluetooth connection.

In operation 1609, the processor 120 may receive a command from the electronic device 101. The electronic device 101 may identify an attached position or an attachment location of the external device 400 based on the magnetic field change values received from the external device 400. For example, in case that the external device 400 is a lighting device, the electronic device 101 may execute a camera application in a designated mode when the external device 400 is attached to the center of the electronic device 101, and the electronic device 101 may execute a camera application in a selfie mode when the external device 400 is attached to the right side of the electronic device 101. The electronic device 101 may transmit a command associated with an executed application to the external device 400.

In operation 1611, the processor 120 may perform an operation based on the received command. The processor 120 may start wireless charging or turn on a light source, based on the command received from the electronic device 101.

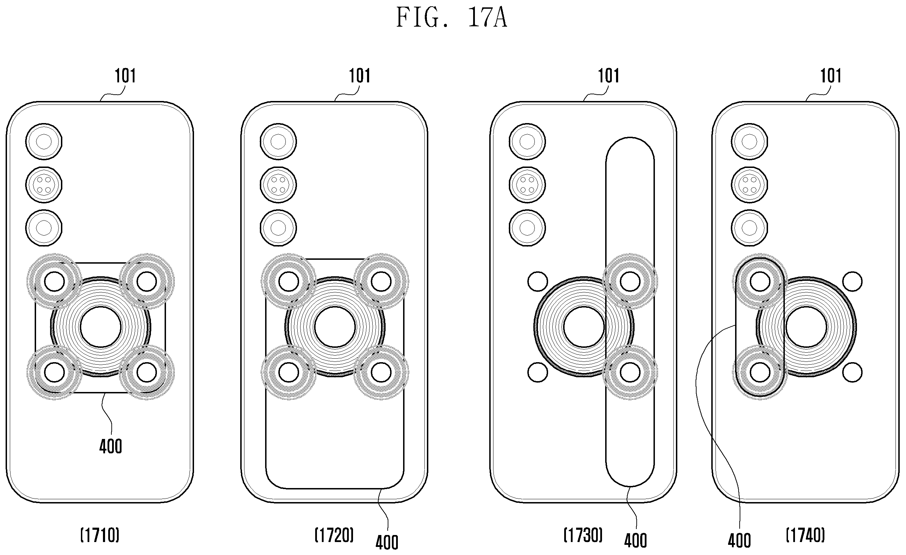

FIGS. 17A to 17C each illustrate an example in which an electronic device identifies an attachment location of an external device, according to an embodiment.

Referring to FIG. 17A, an electronic device (e.g., the electronic device 101 of FIG. 1) according to an embodiment may include multiple magnetic bodies (e.g., the multiple magnetic bodies 201 to 207 of FIG. 2A), at least one Hall sensor (e.g., the multiple Hall sensors 211 to 217 of FIG. 2A), a wireless charging coil (e.g., the wireless charging coil 219 of FIG. 2A), and an NFC antenna (e.g., the NFC antenna 209 of FIG. 2A).

A processor (e.g., the processor 120 of FIG. 1) of the electronic device 101 may detect tagging of an external device 400 by using the NFC antenna (e.g., the NFC antenna 209 of FIG. 2A), and may detect magnetic fields of the multiple magnetic bodies 201 to 207 by using the multiple Hall sensors 211 to 217. The processor 120 may identify, based on changes in the magnetic fields of the multiple magnetic bodies 201 to 207, that the external device 400 is attached to a first attachment locations 1710, 1720 corresponding to the center the electronic device 101. In addition, the processor 120 may identify, based on the changes in the magnetic fields of the multiple magnetic bodies 201 to 207, that the external device 400 is attached to a second attachment location 1730 corresponding to one side of the electronic device 101 (e.g., the right side of the electronic device 101), or to a third attachment location 1740 corresponding to another side of the electronic device 101 (e.g., the left side of the electronic device 101).

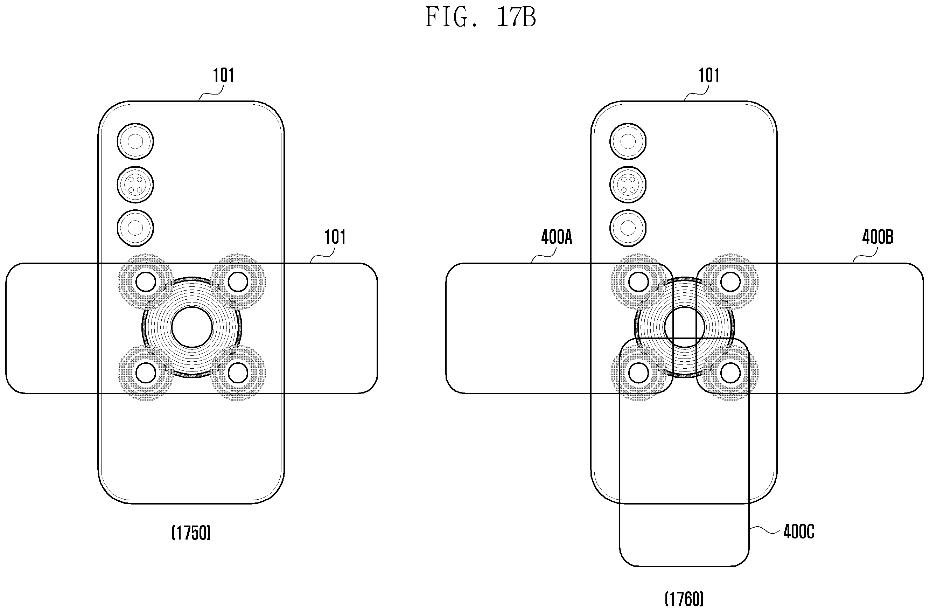

Referring to FIG. 17B, the processor 120 may identify, based on changes in the magnetic fields of the multiple magnetic bodies 201 to 207, that the external device 400 is attached in the horizontal direction 1750. Alternatively, as shown in a first attachment example 1760, the processor 120 may identify that multiple different external devices 400A, 400B, and 400C are attached.

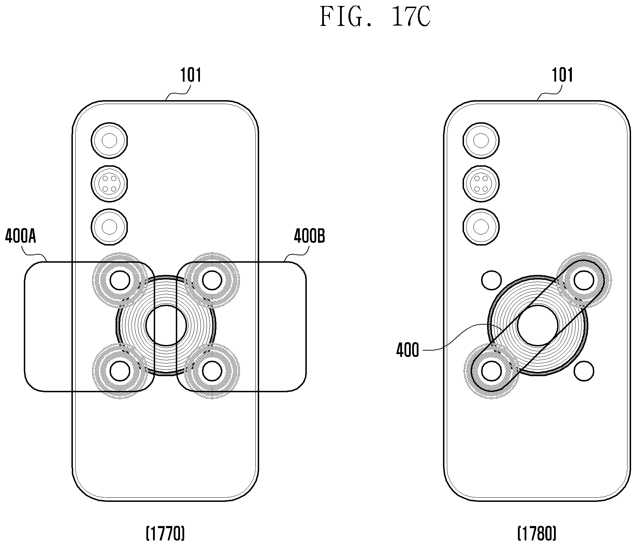

Referring to FIG. 17C, as shown in a second attachment example 1770, the processor 120 may identify that multiple different external devices 400A and 400B are attached. Alternatively, as shown in a third attachment example 1780, the processor 120 may identify, based on changes in the magnetic fields of the multiple magnetic bodies 201 to 207, that the external device 400 is attached in a diagonal direction 1780 of the electronic device 101.

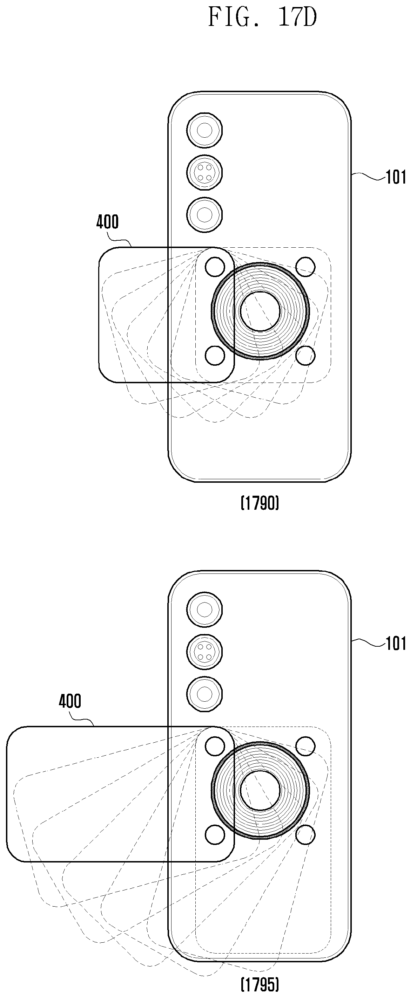

FIG. 17D illustrates an example in which an electronic device detects a movement trajectory of an external device, according to an embodiment.

Referring to FIG. 17D, as shown in a first movement trajectory example 1790, the processor 120 may detect a movement trajectory of an external device 400 having a square shape, based on changes in magnetic fields of the multiple magnetic bodies 201 to 207. Alternatively, as shown in a second movement trajectory example 1595, the processor 120 may detect a movement trajectory of an external device 400 having a rectangular shape, based on the changes in the magnetic fields of the multiple magnetic bodies 201 to 207.

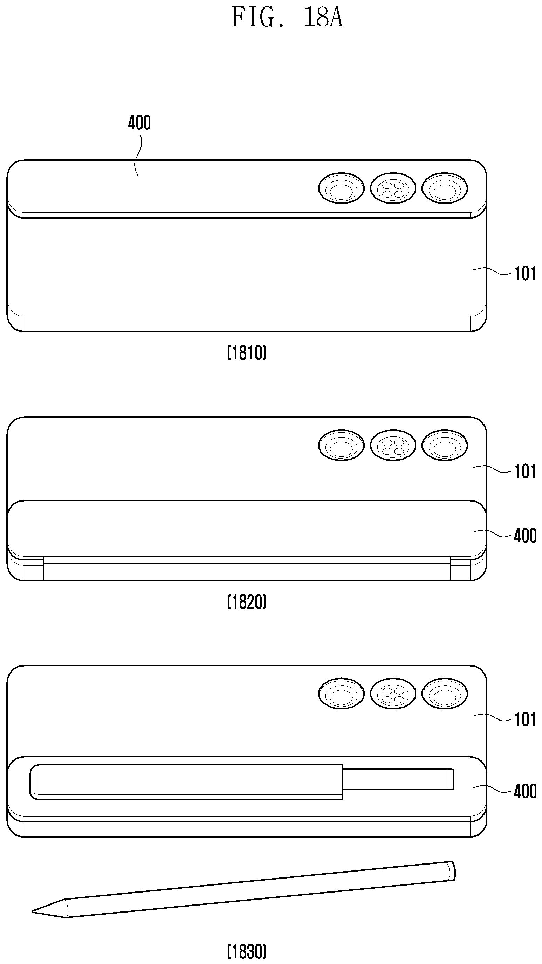

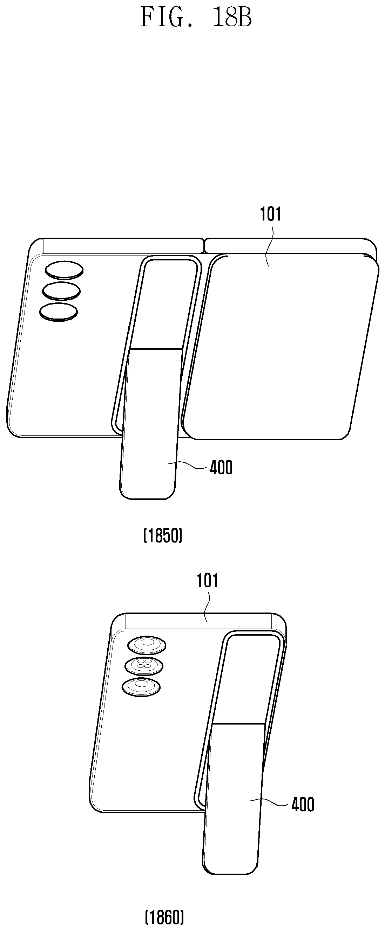

FIGS. 18A and 18B each illustrate an example of the type of an external device tagged to an electronic device according to an embodiment.

Referring to FIG. 18A, an external device (e.g., the external device 400 of FIG. 4A) according to an embodiment may include at least one of a stand 1820 including a wireless charging pad, a vehicle cradle, a tripod mount, a lighting device, a photographic filter 1810, or an electronic pen 1830. An electronic device (e.g., the electronic device 101 of FIG. 1) according to an embodiment may execute a specific application based on at least one of a type of the external device 400, an attached position of the external device 400, an attachment location of the external device 400, a movement trajectory of the external device 400, or a usage history of the electronic device 101, when the external device 400 is tagged.

Referring to FIG. 18B, a specific application may likewise be executed in a flexible (or foldable) electronic device 1850 having at least two flexible display panels, based on at least one of the type of the external device 400, the attached position of the external device 400, the attachment location of the external device 400, the movement trajectory of the external device 400, or the usage history of the electronic device 101, when the external device 400 is tagged. Alternatively, a specific application may likewise be executed in an electronic device 1860 having a bar-type single display area, based on at least one of the type of the external device 400, the attached position of the external device 400, the attachment location of the external device 400, the movement trajectory of the external device 400, or the usage history of the electronic device 101, when the external device 400 is tagged.

According to an embodiment of the disclosure, a method of operating an electronic device 101 including multiple magnetic bodies 201, 203, 205, 207 spaced apart from each other by a predetermined distance, one or more Hall sensors 211, 213 disposed adjacent to the multiple magnetic bodies, and a near-field communication module may include detecting tagging of an external device using the near-field communication module, detecting a change in a magnetic field of at least one of the multiple magnetic bodies 201, 203, 205, 207 using the one or more Hall sensors, and controlling an operation of the electronic device based on the detected change in the magnetic field.

The method may further include identifying the external device in response to the external device being tagged to the electronic device, and displaying information of the identified external device on a display of the electronic device.

The method may further include detecting a change in a magnetic field through the one or more Hall sensors when tagging of the external device is detected, identifying an attached position of the external device based on the detected change in the magnetic field, and executing an application based on the identified attached position of the external device.

The method may further include establishing a low-power Bluetooth connection with the external device, and transmitting, through the low-power Bluetooth connection, a command associated with the executed application to the external device.

The controlling of the operation may include identifying an attachment location of the external device based on the detected change in the magnetic field, executing a first function of an application when the identified attachment location is a first location, and executing a second function of the application when the identified attachment location is a second location, or executing a first application when the identified attachment location is the first location and executing a second application when the identified attachment location is the second location.

The controlling of the operation may include detecting a movement trajectory of the external device based on the detected change in the magnetic field, and executing a designated application or a designated function of a currently displayed application based on the detected movement trajectory.

The method may further include collecting a usage history of the electronic device while the external device is attached to the electronic device, and executing an application differently according to an attached position of the external device by further considering the collected usage history of the electronic device.

The various embodiments of the disclosure disclosed in this specification and the accompanying drawings are merely provided by way of specific examples to easily describe the technical contents of the disclosure and to facilitate understanding of the disclosure, and are not intended to limit the scope of the disclosure. Therefore, the scope of the disclosure should be construed to include not only the embodiments disclosed herein but also all changes or modified forms derived based on the technical spirit of the disclosure.

## Claims

1. An electronic device (101) comprising:
multiple magnetic bodies (201, 203, 205, 207) spaced a designated distance apart from each other;
one or more Hall sensors (211, 213) disposed adjacent to the multiple magnetic bodies;
a memory (130) configured to store instructions; and
a processor (120),
wherein the instructions, when executed by the processor, cause the electronic device to:
detect a change in a magnetic field of at least one of the multiple magnetic bodies by using the one or more Hall sensors; and
control an operation of the electronic device, based on the detected change in the magnetic field.

2. The electronic device of claim 1, wherein the one or more Hall sensors, the number of which is less than or greater than the number of the multiple magnetic bodies or corresponds to the number of the multiple magnetic bodies, are included.

3. The electronic device of claim 1, further comprising a display module (260),
wherein the one or more Hall sensors are disposed under the display module, and the multiple magnetic bodies are arranged under the one or more Hall sensors disposed under the display module to vertically overlap the one or more Hall sensors, or
wherein the one or more Hall sensors disposed under the display module are disposed within the multiple magnetic bodies.

4. The electronic device of claim 1, wherein each of the multiple magnetic bodies is configured to be arranged in a Halbach array.

5. The electronic device of claim 1, further comprising:
a wireless charging coil; and
a near field communication module arranged to surround the wireless charging coil,
wherein the multiple magnetic bodies are configured to be disposed around the near field communication module.

6. The electronic device of claim 5, wherein the instructions, when executed by the processor, cause the electronic device to:
detect tagging of an external device by using the near field communication module; and
identify the external device.

7. The electronic device of claim 6, further comprising a display module (260),
wherein the instructions, when executed by the processor, cause the electronic device to display, on the display module, information on the identified external device.

8. The electronic device of claim 1, wherein the instructions, when executed by the processor, cause the electronic device to:
in case that tagging of an external device is detected, detect a change in a magnetic field through the one or more Hall sensors;
identify an attached position of the external device, based on the detected change in the magnetic field; and
execute an application, based on the identified attached position of the external device.

9. The electronic device of claim 8, wherein the instructions, when executed by the processor, cause the electronic device to:
connect to the external device via low-power Bluetooth; and
transmit a command associated with the executed application to the external device via the low-power Bluetooth.

10. The electronic device of claim 1, wherein the instructions, when executed by the processor, cause the electronic device to:
in case that tagging of an external device is detected, detect a change in a magnetic field via the one or more Hall sensors;
identify an attachment location of the external device, based on the detected change in the magnetic field; and
in case that the identified attachment location is a first location, execute a first function of an application, and in case that the identified attachment location is a second location, execute a second function of the application, or
in case that the identified attachment location is a first location, execute a first application, and in case that the identified attachment location is a second location, execute a second application.

11. The electronic device of claim 1, wherein the instructions, when executed by the processor, cause the electronic device to:
in case that tagging of an external device is detected, detect a change in a magnetic field via the one or more Hall sensors;
detect a movement trajectory of the external device, based on the detected change in the magnetic field; and
execute a designated application or a designated function of an application being displayed, based on the detected movement trajectory.

12. The electronic device of claim 8, wherein the instructions, when executed by the processor, cause the electronic device to:
collect a usage history of the electronic device while the external device is attached to the electronic device; and
execute an application differently according to an attached position of the external device by further considering the collected usage history of the electronic device.

13. The electronic device of claim 1, wherein the instructions, when executed by the processor, cause the electronic device to execute a specific application, based on at least one of a type of an external device tagged to the electronic device, an attached position of the external device, an attachment location of the external device, a movement trajectory of the external device, or a usage history of the electronic device.

14. A method of operating an electronic device (101) comprising multiple magnetic bodies (201, 203, 205, 207) spaced a designated distance apart from each other, one or more Hall sensors (211, 213) disposed adjacent to the multiple magnetic bodies, and a near-field communication module, the method comprising:
detect tagging of an external device by using the near field communication module;
detecting a change in a magnetic field of at least one of the multiple magnetic bodies (201, 203, 205, 207) by using the one or more Hall sensors; and
controlling an operation of the electronic device, based on the detected change in the magnetic field.

15. The method of claim 14, comprising:
identifying the external device according as the external device is tagged to the electronic device;
displaying, on a display of the electronic device, information on the identified external device;
detecting a change in a magnetic field through the one or more Hall sensors;
identifying an attached position of the external device, based on the detected change in the magnetic field; and
executing an application, based on the identified attached position of the external device.
